# EUROPÄISCHE PATENTSCHRIFT

(11) **EP 4 416 757 B1**
(45) Veröffentlichungstag und Bekanntmachung des Hinweises auf die Patenterteilung: **29.10.2025**
(21) Anmeldenummer: 22802034.3
(22) Anmeldetag: 07.10.2022
(51) Int. Cl.: H01L 21/67, B23K 3/08, H01L 23/00, B23K 1/00, B23K 1/008, B23K 3/047, B23K 20/00, B23K 20/02, B23K 20/16, B23K 101/42

(54) **MULTIFUNKTIONALE SINTER- ODER DIFFUSIONSLÖTVORRICHTUNG UND PRESSWERKZEUG**
MULTIFUNCTIONAL SINTERING OR DIFFUSION SOLDERING DEVICE AND PRESSING TOOL
DISPOSITIF MULTIFONCTIONNEL DE FRITTAGE OU DE BRASAGE PAR DIFFUSION ET OUTIL DE COMPRESSION

(30) Priorität: 14.10.2021 DE 102021126716; 14.10.2021 DE 202021105596 U
(43) Veröffentlichungstag der Anmeldung: 21.08.2024
(73) Patentinhaber: PINK GmbH Thermosysteme, 97877 Wertheim (DE)
(72) Erfinder: OETZEL, Christoph, 97896 Freudenberg Boxtal (DE)
(74) Vertreter: Spachmann, Holger
(86) Internationale Anmeldenummer: PCT/EP2022/077939
(87) Internationale Veröffentlichungsnummer: WO 2023/061872

(56) Entgegenhaltungen:
- EP-A2- 3 312 877
- DE-A1- 102016 102 162
- NL-B1- 2 015 895
- US-A- 4 448 149
- US-A1- 2017 243 851
- US-A1- 2019 080 939

## Beschreibung

Die vorliegende Erfindung betrifft eine multifunktionale Sinter- oder Diffusionsvorrichtung zum Verbinden von Komponenten wenigstens einer elektronischen Baugruppe mittels Diffusionslöten oder Drucksintern, wobei die Diffusionslöt- oder Sintervorrichtung eine evakuierbare Prozesskammer umfasst, in welcher ein Oberwerkzeug und ein Unterwerkzeug angeordnet ist, zwischen denen die Baugruppe aufgenommen ist und welche zum Ausüben einer Presskraft relativ zueinander bezüglich ihres Abstandes versetzbar sind.

### Stand der Technik

Gattungsgemäße Diffusionslöt- oder Sintervorrichtungen dienen dazu, Komponenten von elektronischen Baugruppen mechanisch sowie elektrisch und thermisch leitend miteinander zu verbinden. Beispielsweise kann eine gattungsgemäße Diffusionslöt- oder Sintervorrichtung dazu verwendet werden, elektronische Halbleiterbauteile wie Hochleistungsschaltelemente oder Halbleiterbaugruppen und einen Grundkörper, beispielsweise eine Platine, einen Kühlkörper oder dergleichen, mittels Diffusionslöten oder Drucksintern miteinander zu verbinden. Beim Diffusionslöten erfolgt eine Vermischung von Atomen des festen Grundwerkstoffs mit Atomen des flüssigen Lotes unter Anwendung eines Pressdrucks. Dadurch entsteht eine Legierungszone die eine stoffschlüssige Verbindung zwischen Grundwerkstoff und Lot bildet. Beim Drucksintern können zwei oder mehr Komponenten oder Bauelemente, insbesondere elektronische Bauelemente und Substrate, mittels eines Fügewerkstoffs elektrisch und/oder thermisch leitend miteinander verbunden werden, wobei hierbei der verbindende Fügewerkstoff gesintert wird. Eine entsprechende Vorrichtung und ein Verfahren sind beispielsweise aus WO 2014/135151 A2 bekannt.

Gattungsgemäße Diffusionslöt- oder Sintervorrichtungen kommen häufig in automatischen Löt- oder Sinteranlagen, insbesondere in automatischen Mehrkammer-Sinteranlagen zum Einsatz. In EP 2 026 927 B1 ist eine ähnlich aufgebaute Lötvorrichtung mit einer in mehrere Zonen unterteilte Prozesskammer beschrieben.

Das Sintern der elektronischen Baugruppen selbst erfolgt dabei durch Temperierung der zu sinternden Baugruppen bzw. deren Komponenten und Einwirken eines durch das Ober- und Unterwerkzeug vermittelten Pressdrucks. So beträgt beispielsweise bei einer Variante des Drucksinterns, dem Niedertemperatur-Drucksintern, mit Silber als Fügewerkstoff die für die Verbindung und Diffusion erforderliche Temperatur regelmä-ßig zwischen ca. 130°C und 250°C bis 300°C. Der Sintervorgang benötigt bei einem Druck bis maximal 30 MPa eine Zeitdauer von etwa 5 bis 10 Minuten. Mittels neuartiger Sinterpasten können kürze Zeiten erreicht werden.

Damit beim Drucksintern aus dem zwischen den Komponenten eingebrachten Sintermaterial zur Sicherstellung einer mechanisch stabilen, insbesondere scherfesten Verbindung und der gewünschten elektrischen und thermischen Leitfähigkeit eine möglichst geschlossenporige Schicht entsteht, wird die Fügeschicht vor und während des Diffusionsvorgangs durch Druck verdichtet. Zum Ende des Sintervorgangs werden der Druck und die Temperatur gesenkt.

Sintervorrichtungen mit einer oder mehreren Sinterkammern und ein zugehöriges Verfahren sind in DE 10 2014 114 093 B4 beschrieben.

In der DE 10 2017 216 545 A1 ist eine Vorrichtung zur Herstellung einer Niedertemperatur-Drucksinterverbindung für mindestens eine elektronische Baugruppe dargestellt.

In der DE 10 2019 134 410 A1 ist ein Verfahren und eine Anlage zum Verbinden von elektronischen Baugruppen und / oder zum Fertigen von Werkstücken beschrieben.

In der US 2007/0296035 A1 ist eine Vorrichtung zum Verbinden von Halbleiterstrukturen gezeigt.

In der US 2013/0133828 A1 ist eine Vorrichtung zum Verbinden eines zu bearbeitenden Substrats und eines Trägersubstrats beschrieben.

US 2017/243851 A1 (RANGELOV VENTZESLAV [DE] ET AL; Veröffentlichungsdatum: 24. August 2017) und NL 2 015 895 B1 (BESI NETHERLANDS BV [NL]; Veröffentlichungsdatum: 28. Juni 2017) offenbaren Vorrichtungen zum thermischen Verbinden von elektronischen Komponenten.

Eine Herausforderung besteht darin, die zum Diffusionslöten oder Sintern erforderliche Presskraft auf die Baugruppen in möglichst gleichmäßiger Weise aufzubringen, sodass die Komponenten der Baugruppen keinen lokalen oder temporären Druckspitzen ausgesetzt sind. Besonders anspruchsvoll ist die Vermeidung von derartigen lokalen Druckspitzen beim Verbinden von Baugruppen, bei denen mehrere elektronische Bauelemente unterschiedlicher Höhe auf einem Substrat oder Träger angeordnet sind.

Bei gattungsgemäßen Diffusionslöt- oder Sintervorrichtungen kommen oftmals Ober- bzw. Unterwerkzeuge zum Einsatz, welche an die Dimensionen der her-zustellenden elektronischen Baugruppen bzw. deren Komponenten angepasst sind. Beispielsweise können entsprechende Stempel mit unterschiedlicher Länge an dem Presswerkzeug befestigt sein.

In der Regel wird mit einer bestimmten Diffusionslöt- oder Sintervorrichtung nicht nur ein Typ von Baugruppen gefertigt, sondern unterschiedliche Bau-gruppentypen. Oftmals ist bei einem Wechsel des Baugruppentyps auch ein Wechsel des zugehörigen Ober- bzw. Unterwerkzeugs erforderlich. Hierfür ist regelmäßig ein Zugang zur Prozesskammer erforderlich, um die nötigen Um-rüstarbeiten durchführen zu können. Auch für sonstige Wartungs- und/oder Reinigungsarbeiten sowie im Fall von Störungen ist regelmäßig ein Zugang zur Prozesskammer erforderlich. Häufig erfordert ein solcher Zugang jedoch eine größere Anzahl von Arbeitsschritten, in denen Bestandteile der Diffusionslöt- oder Sintervorrichtung demontiert und später wieder montiert werden müssen. Dies führt zu nicht unerheblichen Stillstandszeiten der Diffusionslöt- oder Sintervorrichtung, die den Fertigungsablauf erheblich stören können.

Es ist daher eine Aufgabe der Erfindung, eine Diffusionslöt- oder Sintervorrichtung zu schaffen, bei welcher ein vereinfachter Zugang zur Prozesskammer gegeben ist.

### Beschreibung der Erfindung

Die Lösung der Aufgabe erfolgt durch eine Diffusionslöt- oder Sintervorrichtung mit den Merkmalen des Anspruchs 1. Vorteilhafte Ausführungsformen der Sintervorrichtung sind in den Unteransprüchen angegeben.

Die vorliegende Erfindung sieht eine Diffusionslöt- oder Sintervorrichtung zum Verbinden von Komponenten wenigstens einer elektronischen Baugruppe mittels Diffusionslöten oder Drucksintern vor, umfassend eine evakuierbare Prozesskammer, in welcher ein Oberwerkzeug und ein Unterwerkzeug angeordnet ist, zwischen denen die Baugruppe aufgenommen ist und die zum Ausüben einer Presskraft relativ zueinander bezüglich ihres Abstands versetzbar sind, wobei die Prozesskammer einen Basiskörper, welcher an seiner Oberseite eine Zugangsöffnung aufweist, und einen Deckel umfasst, welcher zwischen einer Schließstellung, in welcher die Zugangsöffnung von dem Deckel verschlossen ist, und einer Öffnungsstellung verstellbar ist, wobei sich das Oberwerkzeug in der Schließstellung des Deckels zumindest während des Ausübens der Presskraft an dem Deckel abstützt.

Die Diffusionslöt- oder Sintervorrichtung kann insbesondere bei einstellbaren Atmosphärenbedingungen, insbesondere unter Vakuum betrieben werden. Dadurch kann diese multifunktional auch für Trocknungszwecke unter Vakuum oder auch bei Atmosphärendruck genutzt werden. Damit können vorzugsweise Löt- oder Sinterpasten getrocknet werden, so dass mehrere Funktionen wie Trocknen, Löten oder Sintern unter einstellbaren Atmosphärenbedingungen multifunktional genutzt werden können. Auch ein Spülen mit einem Reinigungsfluid und zur Korrosionsvermeidung, z.B. mit Stickstoff (N2) oder Ameisensäure ist möglich.

Durch die Anordnung der Zugangsöffnung an der Oberseite der Prozesskammer bzw. an deren Basiskörper wird bei geöffnetem Deckel ein einfacher Zugang zum Inneren der Prozesskammer und insbesondere zu dem Ober- und/oder Unterwerkzeug geschaffen. Die während des Ausübens der Presskraft entstehenden Kräfte bzw. die entsprechenden Gegenkräfte werden in der Schließstellung auf den Deckel übertragen, der somit die Funktion eines Pressenjochs übernimmt.

Die Zugangsöffnung ist bevorzugt in der Schließstellung des Deckels gasdicht verschlossen, beispielsweise mittels einer am Deckel oder an dem Basiskörper vorgesehenen umlaufenden Dichtung.

Somit ist eine Diffusionslöt- oder Sintervorrichtung geschaffen, die zum einen für Trocknungszwecke bei einstellbaren Atmosphärenverhältnissen, insb. unter Vakuum genutzt werden kann, und die für Löt- und Sinterzwecken, insbs. für Kleinserien oder für Entwicklungszwecke multifunktional nutzbar ist.

Bevorzugt ist das Oberwerkzeug an dem Deckel befestigt, sodass das Oberwerkzeug bei geöffnetem Deckel in besonders einfacher Weise ausgewechselt werden kann.

Gemäß einer bevorzugten Ausführungsform ist der Deckel um eine Kippachse schwenkbar an dem Basiskörper angelenkt, wobei bevorzugt am Deckel ein zum Verschwenken des Deckels eingerichteter Betätigungsarm befestigt ist. Die Anlenkung des Deckels an dem Basiskörper bewirkt eine Führung des Deckels während des Öffnens und Schließens. Der Betätigungsarm, der insbesondere als Hebelarm wirken kann, vereinfacht den Öffnungs- und Schließvorgang. Der Betätigungsarm kann fest am Deckel befestigt sein, so dass dieser ohne Umrüstaufwand unmittelbar benutzt werden. Bevorzugt ist der Betätigungsarm lösbar an dem Deckel befestigt und kann für die Dauer des Nichtgebrauchs vom Deckel gelöst werden und zum Beispiel an einem innerhalb der Diffusionslöt- oder Sintervorrichtung vorgesehenen Lagerplatz platzsparend verstaut werden. Der Betätigungsarm kann pneumatisch, hydraulisch oder mittels Federkraft beim Öffnen bzw. Schließen des Deckels unterstützt sein. Alternativ oder zusätzlich kann ein motorischer Antrieb, beispielsweise mittels eines elektromotorischen, hydraulischen oder pneumatischen Antrieb ein Öffnen oder Schließen des Deckels unterstützt oder durchgeführt wird. Dabei kann ggf. auf einen Betätigungsarm verzichtet werden.

Gemäß der Ausführungsform der beanspruchten Erfindung umfasst die Prozesskammer eine zwischen einer Verriegelungsstellung und einer Entriegelungsstellung verstellbare Verriegelungsvorrichtung, welche dazu eingerichtet ist, in ihrer Verriegelungsstellung den Deckel in seiner Schließstellung an dem Basiskörper festzulegen. Die Presskraft bzw. eine entsprechende Gegenkraft wird mittels der Verriegelungsvorrichtung in der Schließstellung von dem Deckel auf den Basiskörper übertragen, wodurch der Deckel entgegen der Presskraft bzw. der Gegenkraft in der Schließstellung gehalten wird. Insbesondere kann in der Verriegelungsstellung ein Gelenk, über welches der Deckel um die Kippachse schwenkbar an dem Basiskörper angelenkt ist, durch die Verriegelungsvorrichtung entlastet werden, sodass die Presskraft bzw. die entsprechende Gegenkraft ausschließlich über die Verriegelungsvorrichtung zwischen dem Deckel und dem Basiskörper übertragen wird. Dadurch kann für das Gelenk eine vergleichsweise einfache Bauweise vorgesehen werden, so dass das Gelenk lediglich der Gewichtskraft des Deckels ohne eine Zusatzbelastung durch die Presskräfte standhalten muss.

Gemäß der Ausführungsform der beanspruchten Erfindung weist die Verriegelungsvorrichtung mehrere schwenkbare Riegelarme auf, welche in der Verriegelungsstellung sowohl mit dem Deckel als auch mit dem Basiskörper formschlüssig verbunden sind. Die Kraftübertragung während des Löt- oder Sintervorgangs erfolgt somit im Wesentlichen über die Riegelarme, wobei durch den Formschluss ein unbeabsichtigtes Öffnen des Deckels vermieden wird.

Gemäß der Ausführungsform der beanspruchten Erfindung ist jeder der Riegelarme an seinem ersten Ende um eine jeweilige Schwenkachse schwenkbar am Deckel befestigt und weist an seinem zweiten Ende einen Riegelabschnitt auf, welcher in der Verriegelungsstellung mit einem jeweiligen, dem Riegelarm zugeordneten, an dem Basiskörper befestigten Riegelbolzen verriegelt ist. Der Eingriff zwischen dem Riegelabschnitt und dem Riegelbolzen in der Verriegelungsstellung kann durch ein Verschwenken der Riegelarme um die jeweilige Schwenkachse gelöst werden, um die Verriegelungsvorrichtung von der Verriegelungsstellung in die Entriegelungsstellung zu verstellen. Die Riegelarme hängen bei dieser erfindungsgemäßen Ausgestaltung aufgrund der Schwerkraft pendelnd am Deckel, wodurch ein Versetzen der Riegelarme in die Verriegelungsstellung vereinfacht ist und insbesondere mit dem Schließvorgang des Deckels kombiniert werden kann, was erfindungsgemäß über geeignet geformte Einlaufschrägen an den zweiten Enden der Riegelarme unterstützt wird.

Bevorzugt erstrecken sich die Zugangsöffnung, der Deckel in seiner Schließstellung und die Schwenkachsen der Riegelarme in jeweiligen horizontalen Ebenen.

Gemäß einer weiteren bevorzugten Ausführungsform sind die Riegelarme an zwei einander gegenüberliegenden Seitenflächen des Deckels angeordnet. Hierdurch wird eine gleichmäßige Kraftübertragung zwischen dem Deckel und dem Basiskörper gewährleistet, wobei sich Kräfte, die ein Verformen oder Verbiegen des Deckels bewirken, weitgehend reduzieren lassen. Der Deckel weist bevorzugt eine quaderförmige Gestalt auf, mit einer Oberseite und einer zur Oberseite parallelen Unterseite, wobei die Unterseite eine mit dem Basiskörper zusammenwirkende Dichtfläche aufweisen kann, zwei ersten Seitenflächen, welche parallel zueinander und senkrecht zur Ober- und Unterseite verlaufen, zwei zweiten Seitenflächen, welche parallel zueinander und senkrecht zur Ober- und Unterseite und senkrecht zu den ersten Seitenflächen verlaufen. Bevorzugt verläuft die vorstehend genannte Kippachse des Deckels parallel zu den ersten Seitenflächen und die Riegelarme sind an den zweiten Seitenflächen angeordnet. Dadurch wird vermieden, dass bei geöffnetem Deckel der Zugang zur Prozesskammer durch die Riegelarme beeinträchtigt wird.

Die Dichtfläche kann durch einen Dichtungsring, ggf. einem im Querschnitt runden, quadratischen, rechteckigen oder elliptischen Dichtungsring ausgebildet sein, der im Atmosphärenzustand einen Abstand zwischen Deckel und Basiskörper ausbildet, durch den ein verriegelndes Verschließen des Deckels nicht möglich ist. Bei Ausbildung eines Unterdrucks, bevorzugt eines Vakuums kann der Dichtungsring derart zwischen Deckel und Basiskörper durch Unterdruck verpresst werden, so dass eine verriegeln des Deckels am Basiskörper mittels Aktivierung der Verriegelungsmechanik erfolgen kann,

Dabei kann ein Verfahren zum Verriegeln und Entriegeln des Deckels wie folgt erfolgen. Beim Verriegeln kann zunächst mittels eines Betätigungsarms der Deckel gegen die Dichtung verpresst werden, bis die Riegelarme selbsttätig in die Riegelbolzen eingreifen. Mittels der Blockhierhebel kann die Stellung der Riegelarme arretiert werden.

Beim Entriegeln kann vorteilhaft zunächst ein Unterdruck bzw. ein Vakuum in der Prozesskammer hergestellt werden, da die Dichtung eine Gegenkraft auf den Deckel ausübt, und somit die Riegelarme in der Verriegelungsstellung gegen die Riegelbolzen verpresst. Durch den auf den Deckel lastenden Atmosphärendruck werden die Riegelarme gegenüber den Riegelbolzen entlastet, da der Deckel in die Dichtung durch den Atmosphärendruck weiter gepresst wird, so dass mittels der Ausrückhebel die Riegelarme kraftfrei in eine Entriegelungsposition verstellt werden können. Durch ein nachfolgendes Aufheben des Vakuums ermöglicht die ausdehnende Dichtung ein stückweise selbsttätiges Verschwenken des Deckels hin zu einer Öffnungsstellung. Mittels des Betätigungsarms kann der Deckel dann relativ leicht in die Öffnungsstellung verschwenkt werden.

Gemäß einer weiteren bevorzugten Ausführungsform weist die Verriegelungsvorrichtung genau drei Riegelarme auf, wobei ein erster und ein zweiter Riegelarm an der einen Seitenfläche und ein dritter Riegelarm an der anderen Seitenfläche angeordnet ist. Bei den genannten Seitenflächen handelt es sich bevorzugt um die vorstehend beschriebenen zweiten Seitenflächen.

Gemäß einer weiteren bevorzugten Ausführungsform sind die Schwenkachsen der Riegelarme sowie die den Riegelarmen zugeordneten Riegelbolzen derart angeordnet, dass die Wirkrichtung einer Zuhaltungskraft, welche aufgrund des Ausübens der Presskraft zwischen dem Deckel und dem Basiskörper über einen jeweiligen verriegelten Riegelarm übertragen wird, zumindest für den ersten und den zweiten Riegelarm parallel zur Wirkrichtung der Presskraft verläuft, und bevorzugt für den dritten Riegelarm schräg zur Wirkrichtung der Presskraft verläuft. Die über den ersten und den zweiten Riegelarm übertragenen Zuhaltungskräfte wirken somit senkrecht zu einer Haupterstreckungsrichtung des Deckels. Dies kann auch für den dritten Riegelarm gelten, wobei jedoch bevorzugt durch den schrägen Verlauf der über den dritten Riegelarm übertragenen Zuhaltungskraft bezogen auf die Wirkrichtung der Presskraft diese Zuhaltungskraft neben einer Normalkomponente, die parallel zur Wirkrichtung der Presskraft verläuft, eine Lateralkomponente aufweist, die senkrecht zur Wirkrichtung der Presskraft und parallel zur Haupterstreckungsebene des Deckels verläuft. Durch diese Lateralkomponente wird der Deckel innerhalb seiner Haupterstreckungsebene vorgespannt. Bevorzugt beträgt der Winkel, der zwischen der Wirkrichtung der Presskraft und der über den dritten Riegelarm übertragenen Zuhaltungskraft eingeschlossen ist, nur wenige Grad, so dass die Lateralkomponente im Vergleich zur Presskraft klein ist.

Gemäß einer weiteren bevorzugten Ausführungsform sind der erste und der zweite Riegelarm derart über eine Koppelstange verbunden, dass der erste und der zweite Riegelarm synchron zwischen der Verriegelungsstellung und der Entriegelungsstellung versetzbar sind. Hierbei bilden die Riegelarme, eine gedachte Verbindungslinie ihrer Schwenkachsen und die Koppelstangen eine Art Parallelogramm mit veränderbaren Winkeln, wodurch der Ver- und Entriegelungsvorgang vereinfacht wird.

Gemäß einer weiteren bevorzugten Ausführungsform sind eine Massenverteilung des dritten Riegelarms und die Position der Schwenkachse des dritten Riegelarms und des dem dritten Riegelarm zugeordneten Riegelbolzens derart gewählt, dass der dritte Riegelarm bei geschlossenem Deckel bei einem Fehlen zusätzlicher Kräfte alleine oder zumindest im Wesentlichen durch den Einfluss der Schwerkraft in seiner Verriegelungsstellung gehalten wird. Die genannte Massenverteilung kann beispielsweise asymmetrisch in Bezug auf eine gedachte Symmetrieebene, welche bei verriegeltem Riegelarm zwischen der Schwenkachse und einer parallel zur Schwenkachse verlaufenden Symmetrieachse des Riegelbolzens aufgespannt wird, verlaufen.

Gemäß einer weiteren bevorzugten Ausführungsform ist wenigstens ein, bevorzugt als Kniehebel ausgebildeter, mit einem jeweiligen zugeordneten Riegelarm zusammenwirkender Blockierhebel vorgesehen, welcher zwischen einer Blockierstellung, in welcher der Blockierhebel den Riegelarm in seiner Verriegelungsstellung gegen ein Versetzen blockiert, und einer Freigabestellung in welcher der Blockierhebel den Riegelarm für ein Versetzen freigibt, versetzbar ist. Alternativ oder zusätzlich ist wenigstens ein, bevorzugt als Kniehebel ausgebildeter, mit einem jeweiligen zugeordneten Riegelarm zusammenwirkender Ausrückhebel vorgesehen, welcher dazu eingerichtet ist, den Riegelarm von seiner Verriegelungsstellung in seine Entriegelungsstellung zu versetzen. Durch den oder die Blockierhebel wird sichergestellt, dass sich die Riegelarme vollständig in der Verriegelungsstellung befinden und somit ein unbeabsichtigtes Entriegeln aufgrund der Presskraft oder etwaiger auf die Riegelarme einwirkender Verstellkräfte vermieden wird. Mittel des oder der Ausrückhebel können die Riegelarme aus ihrer Verriegelungsstellung gelöst werden und ermöglichen somit das anschließende Öffnen des Deckels. Der wenigstens eine Blockierhebel und/oder der wenigstens eine Ausrückhebel sind bevorzugt am Basiskörper angeordnet.

Um sicherzustellen, dass sich die Verriegelungsvorrichtung beim Ausüben der Presskraft stets in ihrer Verriegelungsstellung befindet, können an den Blockierhebeln entsprechende Positionssensoren vorgesehen sein, welche mit einer Steuereinrichtung der Diffusionslöt- oder Sintervorrichtung verbunden sind, die verhindern, dass ein zum Aufbringen der Presskraft vorgesehener Antrieb aktiviert wird, falls sich der oder die Blockierhebel nicht in ihrer Blockierstellung befinden. Alternativ oder zusätzlich können Positionssensoren auch an den Riegelarmen und/oder an den Riegelbolzen vorgesehen sein, welche dafür eingerichtet sind, zu detektieren, ob sich die Riegelarme in ihrer Verriegelungsstellung befinden.

Die vorliegende Erfindung betrifft in einem weiteren Aspekt eine Diffusionslöt- oder Sintervorrichtung zum Verbinden von Komponenten wenigstens einer elektronischen Baugruppe mittels Diffusionslöten oder Drucksintern, insbesondere eine Diffusionslöt- oder Sintervorrichtung nach einer der vorhergehend genannten erfindungsgemäßen oder bevorzugten Ausführungsformen, wobei die Diffusionslöt- oder Sintervorrichtung ein Oberwerkzeug und ein Unterwerkzeug umfasst, zwischen denen die Baugruppe aufgenommen ist und welche zum Ausüben einer Presskraft relativ zueinander bezüglich ihres Abstands versetzbar sind und ein Pressenjoch, an welchem das Oberwerkzeug angeordnet ist, wobei zwischen dem Pressenjoch und dem Oberwerkzeug und / oder im Unterwerkzeug eine elastische Folie, bevorzugt eine Graphitfolie, angeordnet ist. Bei dem Pressenjoch handelt es sich um ein Bauteil, welches zum Abfangen der Presskraft vorgesehen ist. Bevorzugt kann das Pressenjoch durch den Deckel der vorhergehend beschriebenen Ausführungsformen gebildet sein oder kann als ein separates Bauteil gebildet sein, welches beispielsweise zwischen dem Deckel und dem Oberwerkzeug angeordnet sein kann. Das Unterwerkzeug kann mehrteilig, insb. zweiteilig ausgebildet sein, wobei zwischen den beiden Teilen die elastische Folie angeordnet ist. Auch kann unter dem Unterwerkzeug hin zu einer Pressenvorrichtung die elastische Folie angeordnet sein. Die elastische Folie dient dazu, etwaige Nichtparallelitäten zwischen dem Oberwerkzeug und dem Pressenjoch auszugleichen und sorgt für eine Homogenisierung der auf die Komponenten einwirkenden Kräfte. Insbesondere werden Gradientenverläufe der Presskraft über die Fläche eines Pressbereichs reduziert.

Gemäß einer vorteilhaften Ausführungsform der vorstehend genannten Diffusionslöt- oder Sintervorrichtung nach dem weiteren Aspekt weist das Unterwerkzeug an einer der Baugruppe zugewandten Seite ein mit einem Fluid befülltes Druckkissen auf. Das Druckkissen kann auch aus Silikon bestehen. Das Druckkissen bewirkt zusätzlich zu der elastischen Folie eine weitere Homogenisierung der Presskräfte und bewirkt insbesondere den Ausgleich von etwaigen Höhentoleranzen der zu verbindenden Komponenten.

Die Erfindung betrifft in einem weiteren Aspekt ein Presswerkzeug für ein Oberwerkzeug oder ein Unterwerkzeug der Diffusionslöt- oder Sintervorrichtung nach einer der vorstehend genannten erfindungsgemäßen oder bevorzugten Ausführungsformen, wobei das Presswerkzeug eine starre Grundplatte, ein mit der Grundplatte verbundenes Membranteil, welches durch eine biegsame, vorzugsweise topfförmig geformte Silikonmembran oder, bevorzugt aus einer Stahllegierung hergestellten, Metallmembran gebildet ist, und ein mit einer Druckkammer, die vorzugsweise ein mit einem Fluid befülltes Druckkissen umfasst, welches in einem abgeschlossenen Aufnahmeraum angeordnet ist, welcher durch die Grundplatte und das Membranteil in Richtung Pressfläche begrenzt ist. Die Druckkammer kann beispielsweise mit einem Fluid gefüllt sein, oder eine Abstützstruktur umfassen, oder es kann ein Druckkissen eingelegt sein. Druckkissen weisen in der Regel eine flexible Außenhülle auf, welche ein Volumen für das Fluid, beispielsweise Silikon, definieren. Das Druckkissen kann auch vollständig aus Silikon oder einem anderen, thermisch belastbaren, druckhomogenisierenden Material bestehen. Die Außenhüllen unterliegen in der Regel einem hohen Verschleiß, der durch die Anpassung an die Konturen der Komponenten und auch durch Verschmutzungen durch die Komponenten oder den Fügewerkstoff bedingt ist. Zum Schutz des Druckkissens werden bei herkömmlichen Diffusionslöt- oder Sinteranlagen oftmals Folien, insbesondere aus PTFE (Polytetrafluorethylen), zwischen den zu verbindenden Komponenten und dem Druckkissen angeordnet, die nach erfolgtem Löt- oder Sintervorgang entfernt werden. Dies bedingt jedoch einen zusätzlichen Verfahrensschritt, der einerseits die Prozesszeit verlängert und andererseits eine zusätzliche Fehlerquelle darstellt. Durch die erfindungsgemäße Ausgestaltung des Ober- bzw. Unterwerkzeugs übernimmt die Metallmembran einerseits die Funktion einer derartigen Schutzfolie und andererseits die Funktion einer Haltevorrichtung für das Druckkissen. Das Druckkissen wird vor Beschädigungen und Verschmutzungen geschützt, wobei durch die Biegsamkeit der Metallmembran eine ausreichende Anpassung des Ober- bzw. Unterwerkzeugs an die zu verbindenden Komponenten gewährleistet bleibt.

Durch die Bereitstellung eines abgeschlossenen Aufnahmeraums für das Druckkissen werden zudem die Anforderungen an die Druckfestigkeit des Druckkissens reduziert, da sich der während des Pressvorgangs im Druckkissen aufbauende Druck vollständig über die Grundplatte und das Membranteil aufgenommen wird und ein übermäßiges Dehnen einer Außenhülle des Druckkissen vermieden wird.

Gemäß einer bevorzugten Ausführungsform weist das Membranteil einen umlaufenden Randabschnitt auf, welcher zwischen der Grundplatte und einem mit der Grundplatte verbundenen, bevorzugt verschraubten Klemmring eingespannt ist. Mittels des Klemmrings wird eine zuverlässige Verbindung zwischen dem Membranteil und der Grundplatte hergestellt, welche auch einen Austausch des Druckkissens oder auch des Membranteils bei einem Defekt ermöglicht.

Das Membranteil kann eine gleichförmige Dicke, aber auch Bereiche variierender Dicken aufweisen. Insbesondere kann entsprechend einer Anordnung und/oder Oberflächenstruktur von zu verpressenden Bauteilen verdickte und verdünnte Membranbereiche vorgesehen sein, um die Flexibilität des Membranteils im Bauteilbereich anzupassen. Somit kann das Membranteil mittels einer Dickenvariation, d.h. Bereichen verdickter und verdünnter Membranflächen, eine Steifigkeitsstruktur aufweisen, die an eine Bauteilanordnung, insbesondere von in Fertigungswarenträger angeordneten Bauteilen, angepasst ist.

In einer vorteilhaften Weiterbildung kann ein Teilbereich der Druckkammer des Presswerkzeugs, insbesondere zumindest ein Teilbereich eines in der Druckkammer aufgenommen Druckkissens steuerbar fluidbefüllbar ausgebildet sein, insbesondere gasbefüllbar sein. Bevorzugt kann die Fluidbefüllung mittels zumindest eines Füllventils steuerbar sein. Durch die Fluidbefüllung, insbesondere Gasbefüllung eines Teilbereichs der Druckkammer, insbs. eines Teilbereichs, kann zusätzlich oder alternativ zu der durch die Presse mechanisch aufgebrachte Presskraft eine Presskraft durch eine Fluidfüllung in die Druckkammer erzeugt werden. So kann beispielsweise durch Einleitung von Atmosphärengas der Prozesskammer, ggf. auch Spülgas wie Stickstoff etc., in einen Teilbereich der Druckkammer bei Druckverringerung oder Vakuumierung der Prozess-kammer eine Ausdehnung der Druckkammer durch das Membranteil hindurch erfolgen. Hierdurch wird ein vergleichsweise geringer, allerdings in vielen Fällen ausreichender Druck beispielsweise für ein Bondingverfahren, Niederdrucksintern mit Silber oder Kupfer, Diffusionslöten bei beispielsweise bis zu 0,4 MPa, Thermokompressionsbonden bei bspw. bis zu 0,1 MPa etc. auf die Bauelemente erzeugt, ohne dass eine Hydraulik- presse die Pressstempel mechanisch betreibt. Somit ist alleine durch Einstellung einer definierten Prozessatmosphäre in der Prozesskammer und/oder der Druckkammer eine exakt dosierbare Presskraftaufbringung auf das Bauelement möglich, die mit einer mechanischen Presse durch Verfahren von Unter- und Oberwerkzeug relativ zueinander nicht aufbringbar wäre.

Durch diese Ausführungsform kann kostengünstig und einfach ein Presswerkzeug mit geringem Aufwand für eine zusätzliche oder alternative Druckbeaufschlagung bereitgestellt werden. Denn über den Gasdruck und der Prozessatmosphäre bzw. Vakuum in der Prozesskammer, welches für den Prozess grundsätzlich benötigt wird, kann ein gewünschter und gesteuerter Sinterdruck oder Diffusionslötdruck oder Bonddruck auf Halbeiterbauelemente ausgeübt werden, um auch Höhenunterschiede der Bauteile auf dem Bauelement ausgleichen zu können.

Hierzu ist kein zusätzliches Kraftmesssystem oder Druckmesssystem notwendig, den ein Vakuumdrucksensor und eine einfach Softwareflächenumrechnung genügt, um einen gewünschten und eingestellten Sinterdruck oder Diffusionslötdruck oder Bonddruck zu erreichen.

Da die Vakuumkammer im Vakuum über das Presswerkzeug Druck auf das oder die Bauelemente ausübt kann dauerhaft, während des Prozesses, überwacht werden, ob Sauerstoff von außen in die Vakuumkammer eindringt, da ein unerwarteter Kammerdruckanstieg umgehend erkannt werden kann. Hierdurch ist sichergestellt das heiße Bauelemente, insbesondere Kupferoberflächen nicht oxidieren. Eine Drucküberwachung der Bauelemente kann über eine Kraftmessdose, die beispielsweise im Pressenantrieb umfasst ist, vorgenommen werden. So kann beispielsweise ein Klemmen eines Stempels erkannt werden.

In einer vorteilhaften Weiterbildung des Presswerkzeugs kann unterhalb des Membranteils eine Multistempeleinheit mit einer Mehrzahl von Pressstempeln, die in einem Führungsrahmengeführt sind, angeordnet sein. Hierdurch ist es möglich, selektiv Druck auf einzelne Bauteile des Bauelements auszuüben, und insbs. Höhenunterschiede auszugleichen. Auch kann die Pressenenergie reduziert werden, da Druck nur in den Bereichen aufgebaut wird, in der dieser benötigt wird. Teilbereiche des Bauelements können vor Überlastung geschützt werden.

Die Diffusionslöt- oder Sintervorrichtung weist bevorzugt eine Kühl- und/oder Heizeinrichtung auf, die vorteilhaft zumindest in einem Unterwerkzeug des Presswerkzeugs angeordnet ist. Die Kühl- und/oder Heizeinrichtung kann eine Induktions- und/oder Konvektionsheizung, aber auch eine Strahlheizung oder Kontaktheizung umfassen. Weiterhin kann eine Fluidkühlung, insb. mittels Wasser, Luft oder Öl vorgesehen sein.

### Zeichnungen

Weitere Vorteile ergeben sich aus der folgenden Zeichnungsbeschreibung. In den Zeichnungen sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen. Es zeigen:
- **Fig. 1 und 2**: schematische perspektivische Ansichten einer Diffusionslöt- oder Sintervorrichtung gemäß einem Ausführungsbeispiel in verschiedenen Arbeitsstellungen,
- **Fig. 3a, 3b**: eine Seitenansicht der Diffusionslöt- oder Sintervorrichtung von Fig. 1 und 2 in einer Schließ- und Öffnungsstellung,
- **Fig. 4**: eine perspektivische Ansicht der Diffusionslöt- oder Sintervorrichtung von Fig. 1 bis 3 in teilweiser Schnittdarstellung,
- **Fig. 5**: eine perspektivische, halbtransparente Ansicht der Diffusionslöt- oder Sintervorrichtung von Fig. 1 bis 4,
- **Fig. 6a, 6b**: eine schematische Seiten- und Detailansicht einer Verriegelungsvorrichtung der Diffusionslöt- oder Sintervorrichtung von Fig. 1 bis 5;
- **Fig. 7**: schematische Darstellung einer Öffnungs- und Verriegelungsstellung des Deckels der Diffusionslöt- oder Sintervorrichtung der Figs. 1 bis 6
- **Fig. 8**: eine perspektivische Explosionsansicht eines Presswerkzeugs für eine Diffusionslöt- oder Sintervorrichtung gemäß einem Ausführungsbeispiel;
- **Fig. 9a, 9b**: Schnittansichten des Presswerkzeugs von Fig. 8, und
- **Fig. 10,11a-11d**: schematische Seitenansichten von Diffusionslöt- oder Sintervorrichtungen gemäß weiterer Ausführungsbeispiele;
- **Fig. 12a-12c**: ein weiteres Presswerkzeugs in mehreren Verfahrensstufen einer Diffusionslöt- oder Sintervorrichtung gemäß einem Ausführungsbeispiel;

Nachfolgend werden für gleiche oder gleichartige Elemente die gleichen Bezugszeichen verwendet.

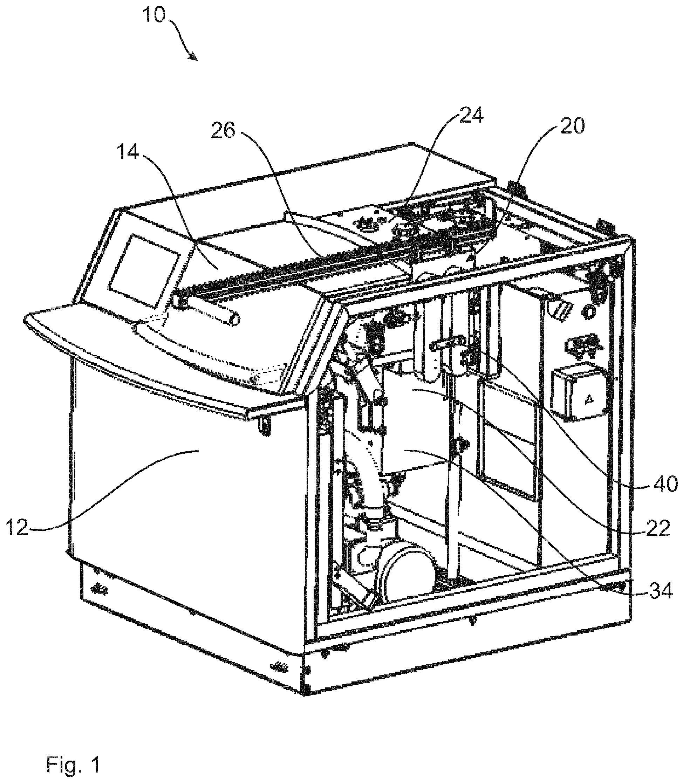

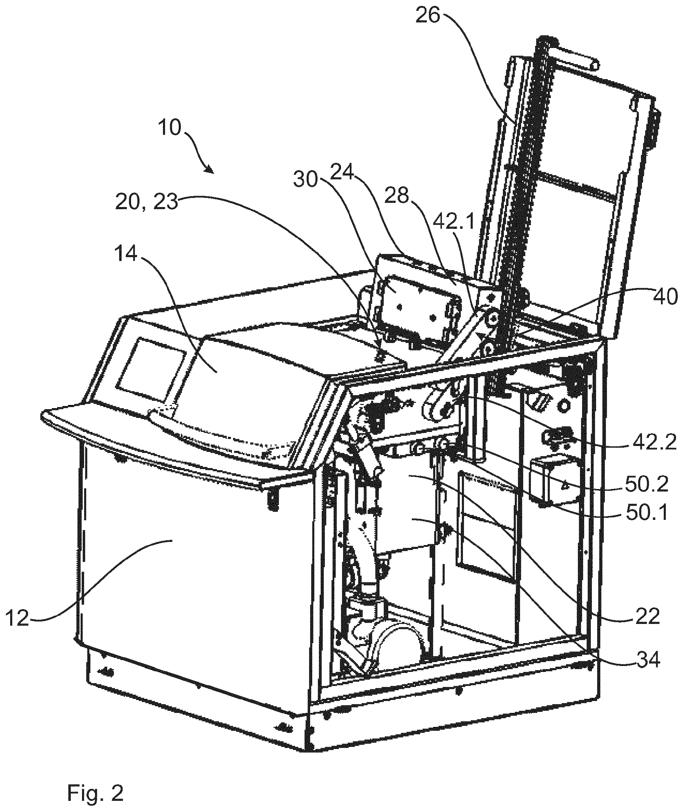

Fig. 1 und 2 zeigen eine Diffusionslöt- oder Sintervorrichtung 10 gemäß einem Ausführungsbeispiel, welche ein Gehäuse 12 aufweist, welches eine evakuierbare Prozess-kammer 20 sowie verschiedene nicht näher bezeichnete Nebenaggregate und Nebeneinrichtungen der Diffusionslöt- oder Sintervorrichtung 10 umschließt. Das Gehäuse 12 weist eine schwenkbare Abdeckung 14 auf, welche in ihrer Öffnungsstellung einen weiteren Zugang zum Inneren des Gehäuses 12 und insbesondere zur Prozesskammer 20 freigibt. Die Prozesskammer 20 kann mit einem Reinigungsfluid wie beispielsweise Stickstoff (N2) oder Ameisensäure spülbar sein. Auch kann innerhalb der Prozesskammer 20 die Druckverhältnisse von Überdruck, Atmosphärendruck bis hin zu Unterdruck und Vakuum einstellbar sein. Insbesondere ein Löt- oder Sinterverfahren unter Vakuum oder einer sauerstofffreien Atmosphäre verhindert unerwünschte Korrosionseffekte.

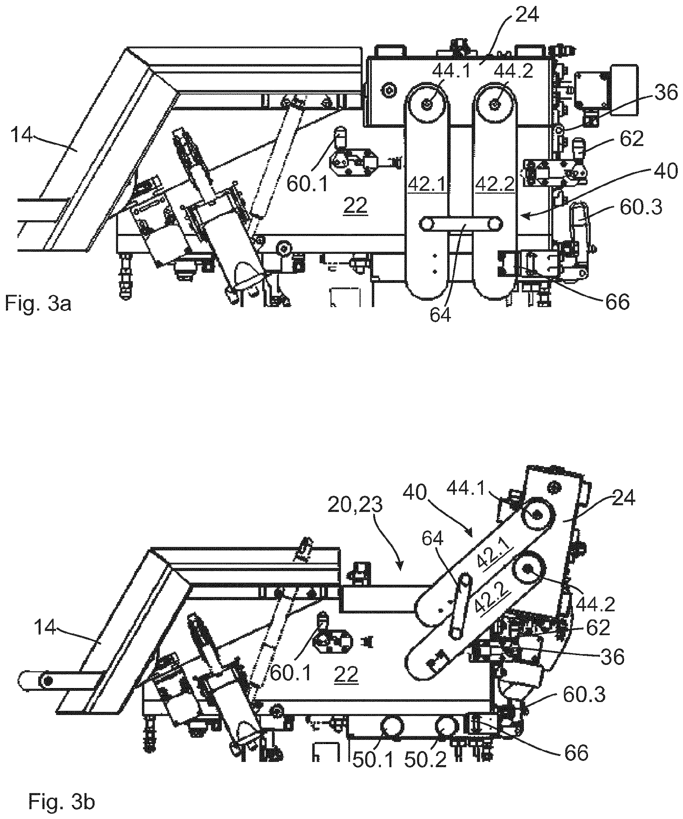

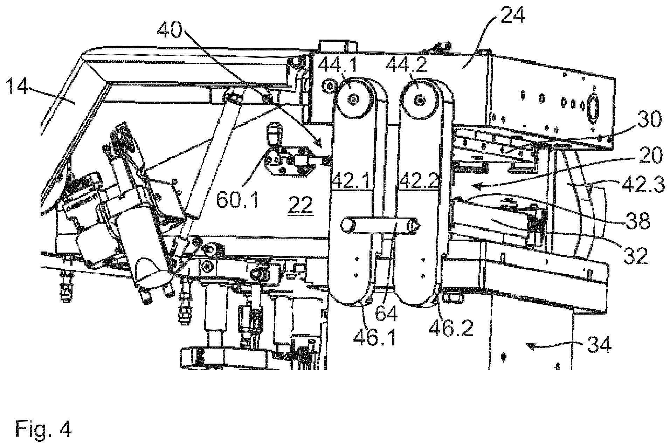

Wie insbesondere zusätzlich auch in Figs. 3a, 3b und 4 dargestellt ist, umfasst die Prozesskammer 20 einen Basiskörper 22, welcher an seiner Oberseite eine Zugangsöffnung 23 aufweist, welche mittels eines zwischen einer Schließstellung (Fig. 1, Fig. 3a) und einer Öffnungsstellung (Fig. 2, Fig. 3b) schwenkbaren Deckels 24 verschließbar ist. Der Deckel 24 weist eine im Grundsatz quaderförmige Gestalt auf, wobei die parallel zu einer Haupterstreckungsrichtung des Deckels 24 verlaufende Ober- und Unterseite sich in der Schließstellung des Deckels 24 in horizontalen Ebenen erstrecken, während sich die Längs- und Querseitenflächen des Deckels 24 in vertikalen Ebenen erstrecken. Der Deckel 24 ist über ein an der rückwärtigen Längsseitenfläche angeordnetes Gelenk 36 an dem Basiskörper 22 angelenkt.

Die Zugangsöffnung 23 ist von einer Dichtfläche umgrenzt, welche mit einem an der Unterseite des Deckels 24 vorgesehenen umlaufenden Dichtring 28 zusammenwirkt. Der Dichtring 28 wird bereits durch die Gewichtskraft des Deckels 24 leicht an die Dichtfläche des Basiskörpers 22 angepresst, sodass die Zugangsöffnung 23 bereits zu Beginn eines Evakuierungsvorgangs gasdicht verschlossen wird und kein Vakuumleck auftreten kann. Der Deckel 24 wird durch den sich aufbauenden Unterdruck, der beispielsweise kleiner 800 hPamBar beträgt, stärker an den Basiskörper 22 angepresst, wobei sich der Dichtring 28 geringfügig verformen kann. Sofern kein Unterdruck anliegt, kann der Dichtring 28, bevorzugt als O-Ring ausgebildet, derart stabil sein und einen Abstand zwischen Deckel 24 und Basiskörper 22 ausbilden, sodass der Deckel 24 nicht verriegelbar ist. Das Gelenk 36 kann ein gewisses Spiel aufweisen, sodass das Anpressen des Deckels 24 bzw. das Verformen des Dichtrings 28 durch das Gelenk 36 nicht behindert wird. Mittels des Unterdrucks von 800 mBar hPa oder weniger kann der Deckel 24 bereits dicht am Basiskörper 22 anliegen.

Zur Betätigung des Deckels 24 ist ein als Hebelarm wirkender Betätigungsarm 26 vorgesehen, der bevorzugt lösbar mit dem Deckel 24 verbunden ist und bei Nichtgebrauch demontiert und innerhalb des Gehäuses 12 gelagert werden kann (vgl. Fig. 1 und 2).

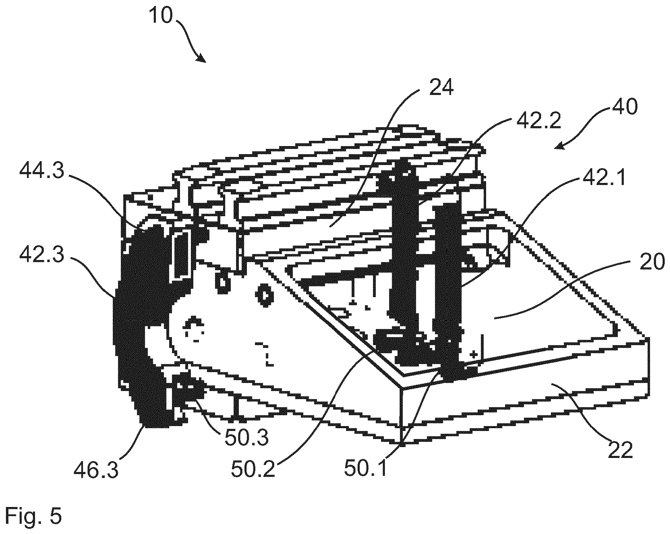

Wie insbesondere in Fig. 3a, 3b und 5 ersichtlich ist, kann die Prozesskammer 20 eine weitere Zugangsöffnung aufweisen, welche einen zusätzlichen Zugang zum Inneren der Prozesskammer 20 ermöglicht. Diese weitere Zugangs-öffnung kann mittels eines weiteren Deckels, beispielsweise über eine Abdeckung 14,

insbesondere über einen gasdichten Deckel oder eine Schleuße, bspw. ein Schiebeschott oder ähnliches verschlossen werden, welcher über nicht näher bezeichnete Betätigungs- und Verriegelungsmittel geöffnet und geschlossen werden kann bzw. am Basiskörper 22 festgelegt werden kann (vgl. Fig. 3a, 3b).

Am Deckel 24 ist ein Oberwerkzeug 30 (Fig. 2 und 4) befestigt, welches in das Innere der Prozesskammer 20 hineinragt. Weiterhin weist die Diffusionslöt- oder Sintervorrichtung 10 ein dem Oberwerkzeug 30 gegenüberliegend angeordnetes Unterwerkzeug 32 auf, wobei zum Durchführen des Diffusionslöt- oder Sintervorgangs die zu verbindende Komponenten von elektronischen Baugruppen zwischen dem Oberwerkzeug 30 und dem Unterwerkzeug 32 angeordnet werden. Die zu verbindenden Komponenten können beispielsweise mit Hilfe eines Werkstückträgers 38 (Fig. 4) in die Prozesskammer 20 eingebracht werden.

Zum Ausüben der Presskraft ist das Unterwerkzeug 32 vertikal versetzbar gelagert und mit einem Pressenantrieb 34 gekoppelt, welcher unterhalb der Prozesskammer 20 angeordnet und mit dem Basiskörper 22 verbunden ist.

Während des Pressvorgangs wird das Unterwerkzeug 32 mittels das Antriebs 34 an das Oberwerkzeug 30 angenähert, wodurch auf das Oberwerkzeug 30 und damit auch auf den Deckel 24 sehr hohe Presskräfte wirken, sodass ein Öffnen des Deckels 24 bei Überschreiten eines bestimmten Pressdrucks alleine durch den in der Prozesskammer 20 herrschenden Unterdruck nicht verhindert werden kann.

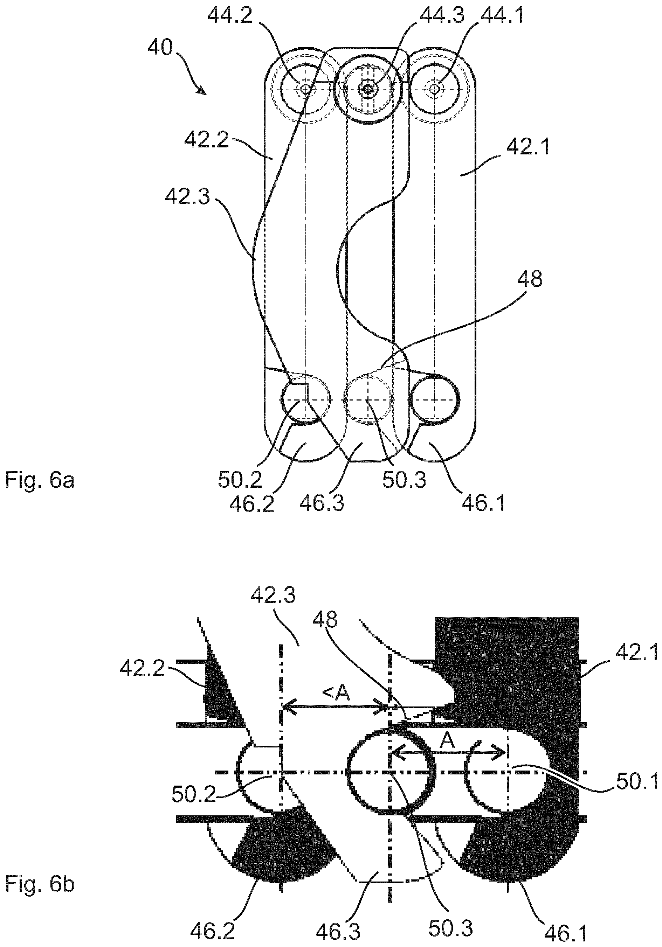

Daher weist die Diffusionslöt- oder Sintervorrichtung 10 eine in den Figs. 5, 6a und 6b im Detail erläuterte Verriegelungsvorrichtung 40 auf, welche in ihrer Verriegelungsstellung den Deckel 24 in seiner Schließstellung an dem Basiskörper 22 festlegt und mehrere schwenkbare Riegelarme 42.1 - 42.3 umfasst, welche an den beiden Querseitenflächen des Deckels 24 vorgesehen sind. Jeder der Riegelarme 42.1 - 42.3 ist mit seinem ersten Ende um eine jeweilige Schwenkachse 44.1 - 44.3 schwenkbar am Deckel 24 befestigt und weist an seinem dem ersten Ende gegenüberliegenden zweiten Ende einen jeweiligen Riegelabschnitt 46.1 - 46.3 auf, welcher in der Verriegelungsstellung mit einem jeweiligen, dem Riegelarm 42.1 - 42.3 zugeordneten, an dem Basiskörper 22 befestigten Riegelbolzen 50.1 - 50.3 verriegelt ist. Die Zuordnung der Schwenkachsen 44.1 - 44.3, der Riegelabschnitte 46.1 - 46.3 und der Riegelbolzen 50.1 - 50.3 zu den Riegelarmen 42.1 - 42.3 ergibt sich durch die letzte, hinter dem Punkt stehende Ziffer der Bezugszeichen. Gemäß dem dargestellten Ausführungsbeispiel können sich die Schwenkachsen 44.1 - 44.3 innerhalb einer gemeinsamen Ebene erstrecken, welche parallel zu einer Haupterstreckungsebene des Deckels 24 verläuft.

Die Riegelarme 42.1 - 42.3 umfassen, wie in Fig. 5 perspektivisch und in Fig. 6a in Draufsicht dargestellt, einen ersten Riegelarm 42.1 und einen zweiten Riegelarm 42.3, welche an einer der Querseitenflächen des Deckels 24 angeordnet sind, sowie einen dritten Riegelarm 42.3, welcher an der der genannten Querseitenfläche gegenüberliegenden Querseitenfläche angeordnet ist. Die Schwenkachsen 44.1, 44.2 des ersten bzw. des zweiten Riegelarms 42.1, 42.3 sowie die Symmetrieachsen der zugeordneten Riegelbolzen 50.1, 50.2 bilden die Ecken eines gedachten Rechtecks, was insbesondere in Fig. 6a gut zu erkennen ist. Der erste und der zweite Riegelarm 42.1, 42.3 sind mittels einer gelenkig befestigten Koppelstange 64 (Figs. 3a, 3b und 4) gekoppelt, sodass die Riegelarme 42.1, 42.2 synchron zwischen ihrer Verriegelungs- und Entriegelungsstellung verschwenkt werden können, wobei die Riegelarme 42.1, 42.2 dabei eine parallelogrammartige Bewegung vollziehen.

Die Schwenkachse 44.3 des dritten Riegelarms 42.3 verläuft in der gleichen Ebene wie die Schwenkachsen 44.1, 44.2, wobei der Abstand der dritten Schwenkachse 44.3 zu den ersten und zweiten Schwenkachsen 44.1, 44.2 gleich ist (vgl. Fig. 6b). Die Symmetrieachse des dritten Riegelbolzens 50.3 verläuft in der gleichen Ebene wie die Symmetrieachsen des ersten und zweiten Riegelbolzens 50.1, 50.2, wobei jedoch der Abstand A der Symmetrieachse des dritten Riegelbolzens 50.3 zu der Symmetrieachse des zweiten Riegelbolzens 50.2 kleiner ist als der Abstand zu der Symmetrieachse des ersten Riegelbolzens 50.1.

Durch die Anordnung von genau drei Riegelarmen 42.1 - 42.3 am Deckel in Verbindung mit der symmetrischen Anordnung ihrer Schwenkachsen 44.1 - 44.3 wird eine möglichst gleichmäßige Zuhaltung des Deckels 24 unter weitgehender Vermeidung von Torsionen oder Verwindungen des Deckels 24 gewährleistet. Dadurch wird gewährleistet, dass das Oberwerkzeug 30 ebenfalls frei von Verformungen oder Verwindungen bleibt, welche negative Auswirkungen auf die Gleichmäßigkeit des auf die zu verbindenden Komponenten zur Folge haben könnten.

Wie insbesondere in Fig. 6b gut zu erkennen ist, sind jedoch die Schwenkachse 44.3 des dritten Riegelarms 42.3 sowie die Symmetrieachse des Riegelbolzens 50.3 in lateraler Richtung betrachtet geringfügig zueinander versetzt. Während die Wirkrichtung einer Zuhaltungskraft, welche aufgrund des Ausübens der Presskraft zwischen dem Deckel 24 und dem Basiskörper 22 über einen jeweiligen verriegelten Riegelarm 42.1 - 42.3 übertragen wird, für den ersten und den zweiten Riegelarm 42.1, 42.2 parallel zur Wirkrichtung der durch ein Versetzen des Unterwerkzeugs 32 erzeugten Presskraft verläuft, verläuft diese Zuhaltungskraft für den dritten Riegelarm 42.3 schräg zur Wirkrichtung der Presskraft. Somit weist die über den dritten Riegelarm 42.3 übertragene Zuhaltungskraft neben einer Normalkomponente, die parallel zur Wirkrichtung der Presskraft verläuft, eine Lateralkomponente auf, die senkrecht zur Wirkrichtung der Presskraft und somit parallel zur Haupterstreckungsebene des Deckels verläuft. Hierdurch wird der Deckel 24 innerhalb seiner Haupterstreckungsebene etwas verspannt, wodurch insbesondere sein Spiel in den gelenkigen Aufhängungen der Riegelarme 42.1 - 42.3 am Deckel 24 in der Verriegelungsstellung vermindert werden kann, sodass sich der Deckel 24 während des Pressvorgangs in einer genau definierten Lage befindet.

Die über den dritten Riegelarm 42.3 ausgeübte Lateralkomponente der Press- bzw. Zuhaltungskraft erzeugt jedoch keine Torsion des Deckels 24 um eine in seiner Haupterstreckungsrichtung verlaufende Achse, so dass die Planarität des Deckels 24 nicht beeinträchtigt wird.

Wie in Fig. 5 und 6a gut zu erkennen ist, weist der dritte Riegelarm 42.3 eine gekröpfte Gestalt auf, wodurch eine asymmetrische Massenverteilung erreicht wird, so dass der dritte Riegelarm 42.3 bei geschlossenem Deckel 24 und bei einem Fehlen zusätzlicher Kräfte durch den Einfluss der Schwerkraft in seine Verriegelungsstellung versetzt und in dieser Verriegelungsstellung gehalten wird. Dies erleichtert das Schließen und Verriegeln des Deckels 24 am Basiskörper 22.

Um zu gewährleisten, dass die Riegelarme 42.1 - 42.3 vollständig in ihre Verriegelungsstellung gelangen und auch bei einsetzender Presskraft in dieser Verriegelungsstellung verbleiben und nicht versehentlich herausrutschen können, sind seitlich am Basiskörper 22 jeweilige Blockierhebel 60.1, 60.3 vorgesehen, welche als Kniehebel ausgebildet sein können und ein mit einer Signalfarbe versehenes Betätigungselement aufweisen können, sodass der Benutzer zuverlässig erkennen kann, ob sich die Riegelarme 42.1 - 42.3 tatsächlich in ihrer Verriegelungsstellung befinden und in dieser durch den jeweiligen Blockierhebel 60.1, 60.3 blockiert sind. Während der Blockierhebel 60.1 mit dem Riegelarm 42.1 und indirekt über die Koppelstange 64 auch mit dem Riegelarm 42.2 zusammenwirkt, wirkt der auf der gegenüberliegenden Seite des Basiskörpers 22 angeordnete Blockierhebel 60.3 mit dem Riegelarm 42.3 zusammen.

Wenn sich der Blockierhebel 60.1 in seiner Freigabestellung befindet (vgl. Fig. 3b), können die Riegelarme 42.1 - 42.3 mittels eines ebenfalls als Kniehebel ausgebildeten Ausrückhebels 62 von ihrer Verriegelungsstellung in ihre Entriegelungsstellung verschwenkt werden. Für den dritten Riegelarm 42.3 kann ein solcher Ausrückhebel auch entfallen, da hier das Entriegeln automatisch beim Öffnen des Deckels 24 erfolgen kann. Der Verriegelungsabschnitt 46.3 kann hierfür beispielsweise mittels einer Auslaufschräge 48 sowie durch Unterstützung der Schwerkraft von seiner Verriegelungsstellung in die Entriegelungsstellung versetzt und damit außer Eingriff mit dem dritten Riegelbolzen 50.3 gebracht werden.

Um eine zusätzliche Überwachung der Verriegelungsstellung der Riegelarme 42.1 - 42.3 zu gewährleisten, kann an einem oder mehreren der Riegelarme 42.1 - 42.3 ein Verriegelungssensor vorgesehen sein, welcher z.B. als optischer, magnetischer, elektrostatischer oder mechanischer Sensor ausgebildet sein kann und detektiert, ob sich ein jeweiliger Riegelarm 42.1 - 42.3 mit dem zugeordneten Riegelbolzen 50.1 - 50.3 in Eingriff befindet. Beim vorliegenden Ausführungsbeispiel ist ein solcher Verriegelungssensor 66 am zweiten Riegelarm 42.2 vorgesehen (Figs. 3a, 3b und 4).

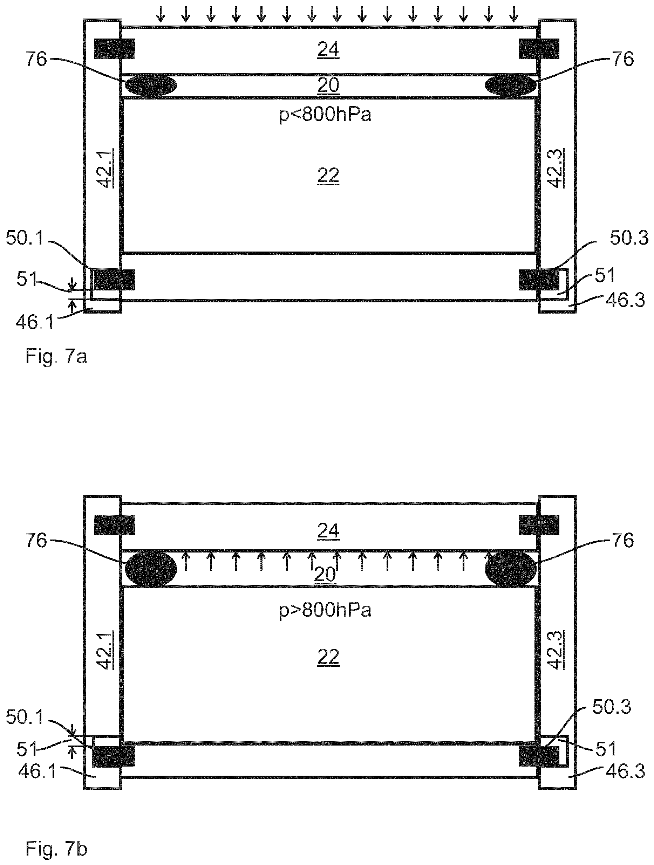

Wie in der Fig. 7 dargestellt kann ein Öffnen und Schließen des Deckels 24 unterstützt durch einen Unterdruck von beispielsweise 800 hPa oder weniger und dem Dichtring 76 unterstützt werden. So kann, wie in Fig. 7b dargestellt, der Deckel 24 in Richtung des Basiskörpers 22 zunächst durch den Dichtring 76 beabstandet bleiben, der die Einnahme der Verriegelungsstellung der Riegelarme 42.1-42.3 zunächst nicht erlaubt. Durch Evakuierung der Vakuumkammer 20, kann der Atmosphärendruck, angedeutet durch Pfeile auf den Deckel 24 in Richtung Prozesskammer 20 den Dichtring 76 derart verpressen, dass die Riegelarme 42.1-42.3 durch Einfluss der Schwerkraft selbsttätig in eine Verriegelungsstellung überführt werden, siehe Fig. 7a. Ein oder mehrere Verriegelungssensoren 66 überwachen die Einnahme der korrekten Verriegelungsstellung. Durch die Blockierhebel 60.1-60.3 kann die Position der Riegelarme 42.1-42.3 verriegelt werden, so dass im drucklosen Zustand kein Öffnen des Deckels möglich ist, da der Dichtring 76 den Deckel gegenüber der Verriegelungsvorrichtung 40 verpresst. Zur Ermöglichung der Verriegelungsstellung ist ein Spiel 51 in zumindest einem Riegelabschnitt 46.1-46.3 zumindest eines Riegelarms 42.1-42.3 zur Aufnahme eines Riegelbolzens 50.1-50-3 vorgesehen.

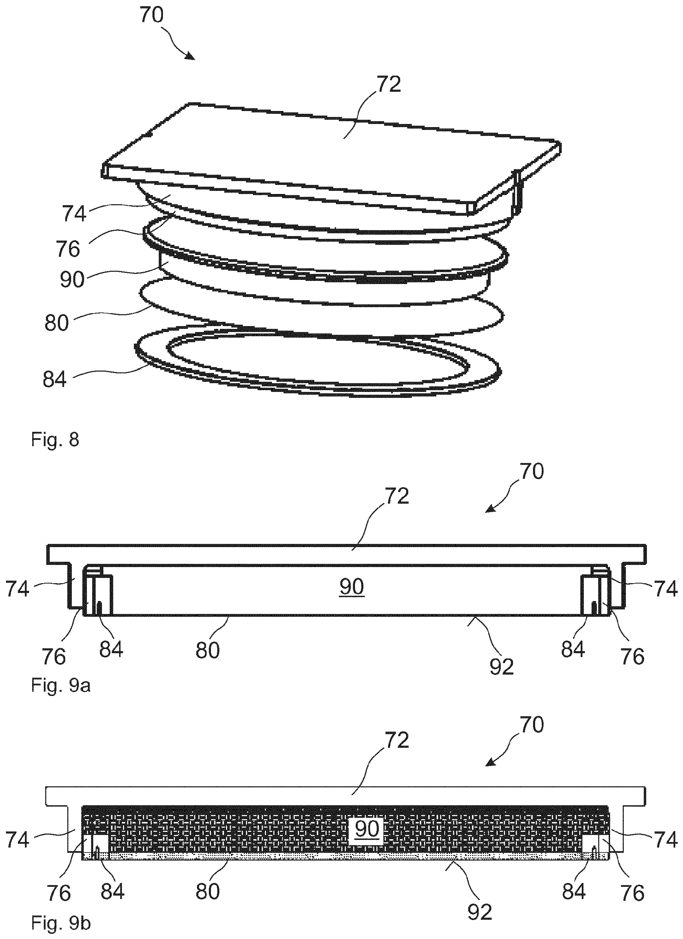

Gemäß einem weiteren Aspekt der Erfindung zeigen Fig. 8 und 9a bzw. 9b ein Presswerkzeug 70 für eine Diffusionslöt- oder Sintervorrichtung, insbesondere die Diffusionslöt- oder Sintervorrichtung 10 des vorstehend beschriebenen Ausführungsbeispiels. Das Presswerkzeug 70 kann sowohl als ein Oberwerkzeug als auch als ein Unterwerkzeug ausgestaltet sein und umfasst eine Grundplatte 72 und einen sich von der Grundplatte 72 weg erstreckenden zylinderförmigen Wandungsabschnitt 74. Die im Ausführungsbeispiel quadratische Form der Grundplatte 72 und die zylindrische Form des Wandungsabschnitts 74 sind rein beispielhaft und können jeweils auch abweichende Formen aufweisen.

Einen durch die Grundplatte 72 und den Wandungsabschnitt 74 definierten Hohlraum wird durch ein Membranteil 80 abgeschlossen. Das Membranteil 80 kann flach oder topfförmig, beispielsweise durch Tiefziehen aus einer Metallmembran oder einer Metallfolie hergestellt sein, wobei als bevorzugtes Material für das Membranteil 80 eine Stahllegierung, beispielsweise eine Chrom-Nickel-Stahllegierung, vorgesehen ist. Das Membranteil 80 umgrenzt den Hohlraum an seiner der Grundplatte 72 abgewandten Seite, in der beispielsweise ein Druckkissen 90 als Druckkammer aufnehmbar ist. Alternativ kann im Hohlraum auch eine Stützstruktur, beispielsweise ein mechanisch weiches Metall, eine Fluidkammer oder ein Silikonkissen aufgenommen sein. Das Membranteil 80 kann einen umlaufenden Randabschnitt aufweisen, welcher sich seitlich bis an den Wandungsabschnitt 74 erstreckt und der beispielsweise zwischen der Grundplatte 72 und einem Klemmring 84 verklemmt. Der Klemmring 84 kann mit der Grundplatte 72 verschraubt sein, insbesondere am offenen Abschnitt des Wandungsabschnitts 74 befestigt sein, und kann den bevorzugt topfartigen Randabschnitt des Membranteils 80 befestigten. Alternativ kann das Membranteil 80 unmittelbar an den Wandungsabschnitt 74 befestigt werden. In einer in dem Klemmring 84 angeordneten Umfangsnut kann ein Dichtring 76 eingelassen werden, welcher mit einer Innenumfangsfläche des Wandungsabschnitts 74 zusammenwirken kann.

Der zwischen der Grundplatte 72 und dem Membranteil 80 ausgebildete Hohlraum definiert einen allseitig abgeschlossenen Aufnahmeraum für ein Druckkissen oder eine Druckkammer 90, siehe Fig. 9a, 9b. Dieser Aufnahmeraum kann beispielsweise eine mit einem Fluid, beispielsweise Silikon oder Öl, befüllte Druckkammer 90 ausbilden, siehe Fig. 9a, oder ein Druckkissen 90 eingelegt sein, siehe Fig. 9b, wobei das Drucckissen 90 beispielsweise ein Öl-befülltes Kissen oder ein Silikonkissen oder ähnliches sein kann. Das Druckkissen 90 kann beispielsweise Gewindeeinsätze aufweisen, welche es gestatten, das Druckkissen 90 mit der Grundplatte 72 zu verschrauben.

Die Dicke des Membranteils 80 ist derart gewählt, dass das Membranteil 80 im Bereich einer Pressfläche 92, welche mit den zu verbindenden Komponenten einer elektronischen Baugruppe zusammenwirkt, eine ausreichende Elastizität aufweist, um sich um ein geeignetes Maß zu verformen und einen Druckausgleich zwischen benachbarten Komponenten über das Druckkissen 90 zu vermitteln. Das Membranteil 80 kann eine gleichförmige Dicke aufweisen, aber auch Bereiche variierender Dicke. So kann das Membranteil 80 bereichsweise verdickt oder verdünnt sein, und somit eine Strukturierung entsprechend unterschiedlichen Druckbereichszonen je nach Anordnungsstruktur von zu verpressenden Bauteilen 130 aufweisen. Das Sinterwerkzeug 70 kann eine Gesamthöhe von ca. 40 mm aufweisen, wobei die Größenverhältnisse in der Darstellung Fig. 8 und 9 nicht zwingend maßstäblich sein müssen. Insbesondere kann die Dicke des Membranteils 80 auch kleiner als dargestellt sein.

Der Dichtring 76 kann einen mehrlagigen Aufbau aufweisen, wobei die Darstellung des Dichtrings 76 in Fig. 8, 9a, 9b vereinfacht sind. Grundsätzlich ist es denkbar, den Klemmring 84 anstatt mit einer eingelassenen Dichtringnut auch mehrteilig auszuführen.

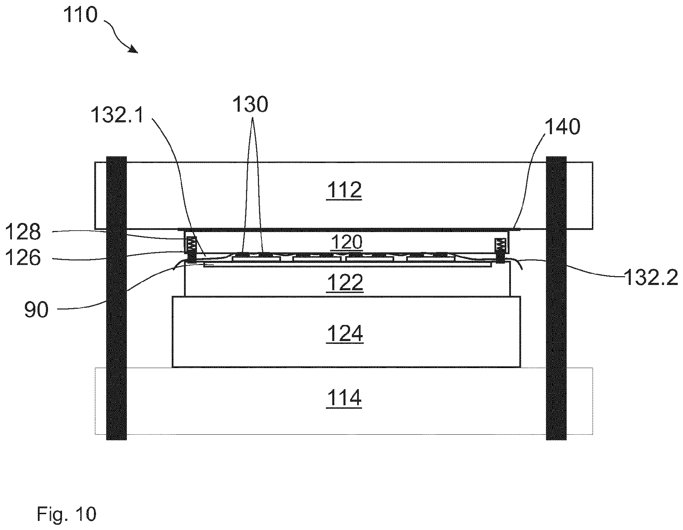

Mit Bezug nun auf Fig. 10 bis 12 werden weitere Diffusionslöt- oder Sintervorrichtungen 110, 210, 310 beschrieben, wobei die in diesem Zusammenhang beschriebenen Merkmale sowohl in Kombination mit den Merkmalen der vorstehend beschriebenen Diffusionslöt- oder Sintervorrichtung 10 gemäß Fig. 1 bis 7 verwirklicht werden können als auch bei anderen, gattungsähnlichen Sintervorrichtungen zum Einsatz kommen können.

Die in Fig. 10 schematisch und nicht maßstäblich dargestellte Diffusionslöt- oder Sintervorrichtung 110 umfasst ein Pressenjoch 112 eines Oberwerkzeugs und einen unterhalb des Pressenjochs vorgesehenen Pressstempel 114 des Unterwerkzeugs, welche mittels eines Antriebs relativ zueinander versetzbar sind, um eine Presskraft auf die zwischen dem Pressenjoch 112 und dem Pressstempel 114 angeordneten zu verbindenden Komponenten / Bauelemente 130 einer elektronischen Baugruppe aufzubringen. Der Antrieb kann sowohl auf das Pressenjoch 112 als auch auf den Pressstempel 114 wirken und kann beispielsweise als hydraulische Presse ausgeführt sein. An der Unterseite des Pressenjochs 112 ist ein oberes Hartwerkzeug 120 angeordnet, wobei zwischen dem Pressenjoch 112 und dem oberen Hartwerkzeug 120 eine Graphitfolie 140 vorgesehen ist, welche einen gewissen Druck- bzw. Gradientenausgleich zwischen dem Pressenjoch 112 und dem oberen Hartwerkzeug 120 bewirken kann. Die Graphitfolie 140 kann in Art und Dicke derart angepasst sein, dass sie im Sinne einer elastischen Folie beim Ausüben einer Presskraft zwischen Ober- und Unterwerkzeug eine planare Ausrichtung zwischen oberem Hartwerkzeug 120 und einem Unterwerkzeug 122 erreichen kann. Somit ist eine exakte parallele Ausrichtung von Ober- und Unterwerkzeug mittels der Graphitfolie 140 herstellbar.

Auf der Oberseite des Pressstempels 114 befindet sich eine Heizplatte 124, welche neben einer oder mehrerer Heizvorrichtungen auch eine oder mehrere Kühlvorrichtungen aufweisen kann. Auf der Oberseite der Heizplatte 124 ist das Unterwerkzeug 122 angeordnet, welches an seiner Oberfläche eine Aufnahme für ein elastisches Drucckissen 90 aufweist. Alternativ oder zusätzlich kann im oberen Werkzeug 120 ein Druckkissen in einer Ausführung als Softwerkzeug vorgesehen sein, so kann das obere Hartwerkzeug 120 und / oder das Unterwerkzeug 122 durch ein Presswerkzeug 70, wie in den Figs. 8, 9a oder 9b dargestellt, ersetzt werden.

Auf dem Druckkissen 90 sind die zu verbindenden Komponenten oder Bauelemente 130 angeordnet. Zum Schutz vor Beschädigungen und/oder Verschmutzungen des Druckkissens 90 und des oberen Hartwerkzeugs 120 und des Unterwerkzeugs 122 sind oberhalb und unterhalb der Bauelemente 130 jeweilige Trennfolien 132.1, 132.2 angeordnet, welche beispielsweise durch entsprechende Zuschnitte von Metallfolien oder PTFE-Folien (Polytetrafluorethylen-Folien) gebildet sein können und zum Beispiel eine Dicke von etwa 250 µm aufweisen. Um ein versehentliches Verrutschen der Trennfolien 132.1, 132.2 zu vermeiden, kann an dem oberen Hartwerkzeug 120 ein mittels Druckfedern 128 vorgespannter Druckring 126 vorgesehen sein, welcher beim Zusammenführen vom Pressenjoch 112 und Pressstempel 114 auf einem umlaufenden Randabschnitt des Unterwerkzeugs 122 aufsetzt und dabei die Trennfolien 132.1,

132.2 einklemmt. Alternativ kann auf eine Trennfolie 132 verzichtet werden, insbesondere, sofern eine Metallfolie 80 nach der Ausführung nach Figs. 8, 9a, 9b eingesetzt wird

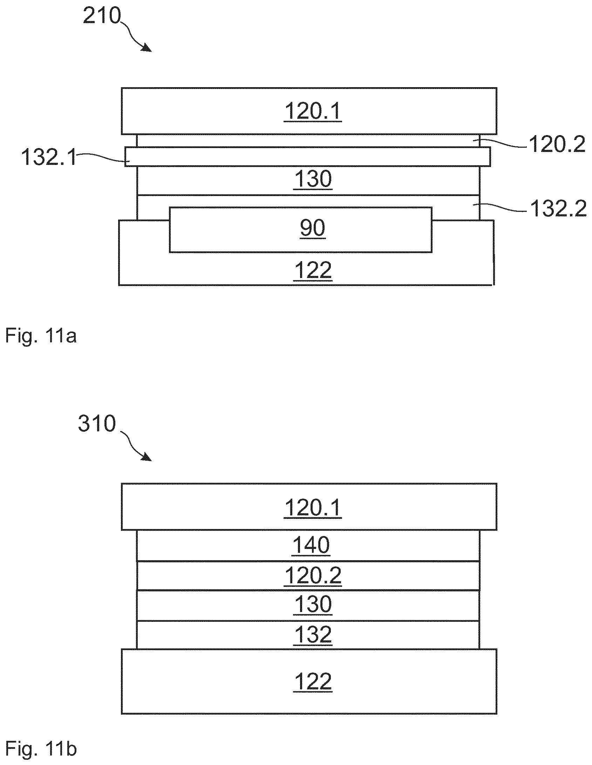

Weitere beispielhafte Diffusionslöt- oder Sintervorrichtung 210 sind in Figs. 11a bis 11d dargestellt, wobei deren Aufbau im Prinzip dem Aufbau der Diffusionslöt- oder Sintervorrichtung 110 von Fig. 10 entspricht, jedoch vereinfacht und noch weiter unmaßstäblich dargestellt ist. Nachfolgend werden somit hier nur die wesentlichen Unterschiede erläutert. In der Darstellung von Fig. 11a sind das Pressenjoch und der Pressstempel nicht dargestellt. Am Pressenjoch ist ein oberes Hartwerkzeug 120 mit einem zweiteiligen Aufbau umfassend ein erstes oberes Hartwerkzeug 120.1 und ein zweites oberes Hartwerkzeug 120.2 angeordnet. Eine elastische Ausgleichsfolie, z.B. eine Graphitfolie ist nicht vorgesehen. Das Unterwerkzeug 122 weist wie die Diffusionslöt- oder Sintervorrichtung 110 ein eingebettetes Druckkissen 90 auf, auf welchem die zu verbindenden Bauelemente 130 gelagert sind. Oberhalb der Bauelemente 130 befindet sich eine nicht maßstäblich dargestellte Trennfolie 132.1 und unterhalb der Bauelemente 130 eine weitere Trennfolie 132.2, was dem Aufbau der Diffusionslöt- oder Sintervorrichtung 110 entspricht. Die Dicke der Trennfolien 132.1, 132.2 kann zum Beispiel 250 µm betragen. Ein Druckring zum Fixieren der Trennfolien 132.1, 132.2 ist nicht dargestellt, kann jedoch ähnlich wie bei der Diffusionslöt- oder Sintervorrichtung 110 vorgesehen sein. Alternativ kann das Druckkissen 90 durch eine Metallfolie 80, vergleichbar in den Figs. 8, 9a, 9b gegenüber den Bauelementen 130 abgegrenzt sein.

Fig. 11b zeigt eine Diffusionslöt- oder Sintervorrichtung 310, welche wiederum eine Abwandlung der Diffusionslöt- oder Sintervorrichtungen 110, 210 von Fig. 10 bzw. 11a darstellt. Das Pressenjoch und der Pressstempel sind nicht gezeigt. Der Aufbau des oberen Hartwerkzeugs ist ähnlich wie bei der Diffusionslöt- oder Sintervorrichtung 210 der Fig. 11a zweiteilig und umfasst ein erstes oberes Hartwerkzeug 120.1 und ein unterhalb angeordnetes zweites oberes Hartwerkzeug 120.2. Im Unterschied zur Diffusionslöt- oder Sintervorrichtung 210 der Fig. 11a ist zwischen dem ersten oberen Hartwerkzeug 120.1 und dem zweiten oberen Hartwerkzeug 120.2 eine elastische Folie 140 zur Herstellung von Parallelität zwischen Ober- und Unterwerkzeug angeordnet. Ein weiterer Unterschied besteht darin, dass nur eine einzige Trennfolie 132 vorgesehen ist, welche zwischen den Bauteilen 130 und dem Unterwerkzeug 122 angeordnet ist und deren Dicke zum Beispiel 500 µm betragen kann.

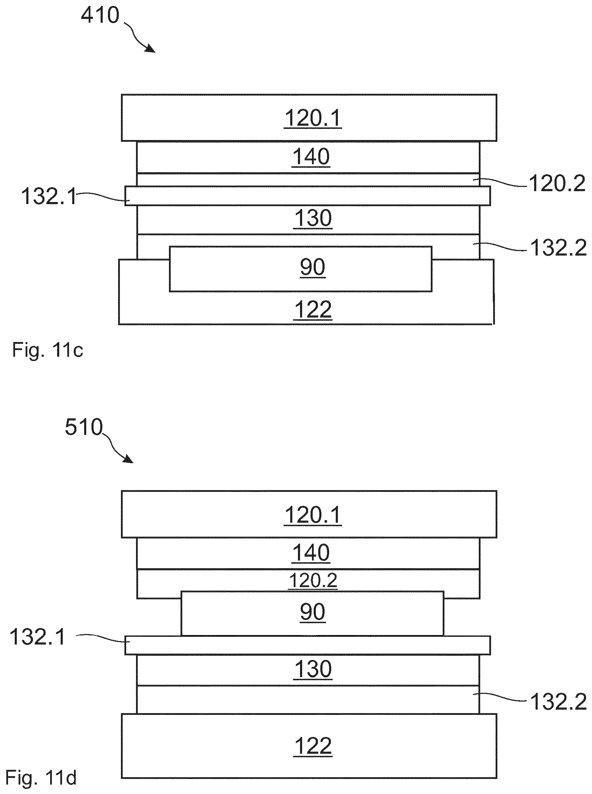

Die Ausführungsform der Diffusionslöt- oder Sintervorrichtung 410 der Fig. 11c entspricht im Wesentlichen der Ausführung der Fig. 11a, mit dem Unterschied, dass zwischen dem ersten oberen Hartwerkzeug 120.1 und dem zweiten oberen Hartwerkzeug 120.2 eine elastische Folie 140 zur Herstellung von Parallelität zwischen Ober- und Unterwerkzeug angeordnet ist. Insofern entspricht die Ausführungsform 410 einer Kombination der Ausführungsformen 210 und 310.

In Fig. 11d ist eine weitere Ausführungsform einer Diffusionslöt- oder Sintervorrichtung 510 dargestellt. Diese entspricht im Wesentlichen der Ausführungsform der Figs. 11c, mit dem Unterschied, dass das Druckkissen 90 nicht im Unterwerkzeug 122 angeordnet ist, sondern im Oberwerkzeug auf der Unterseite des zweiten Werkzeugs 120.2 angeordnet ist.

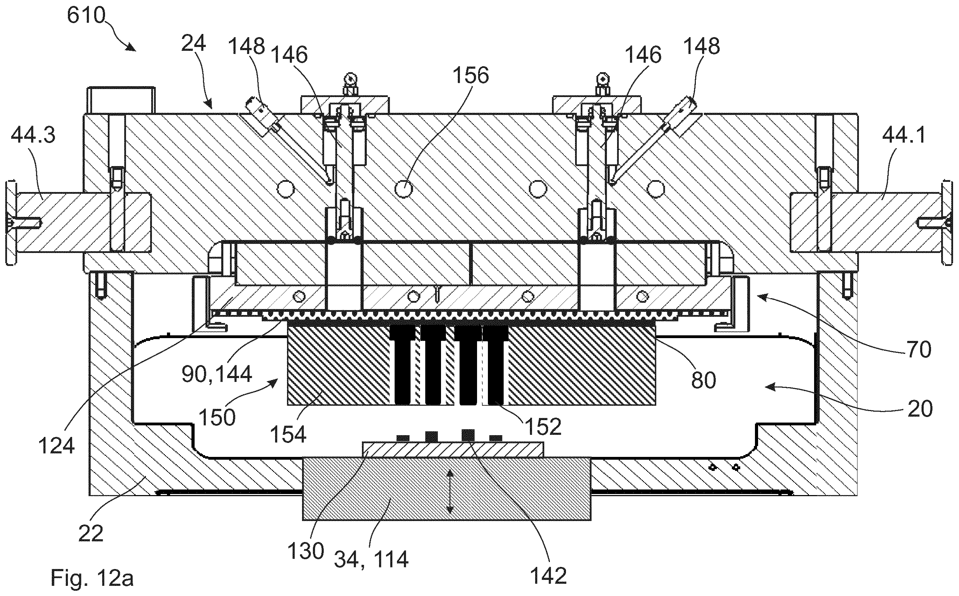

Die Figs. 12a bis 12c zeigen eine Ausführungsform einer Diffusionslöt- oder Sintervorrichtungen 610 in Kombination mit einem Pressenwerkzeug 70, wie es beispielsweise in den Figs. 8 und 9a, 9b dargestellt ist. Die aufklappbare Prozesskammer 20 umfasst einen Basiskörper 22 und einen Deckel 24. Mittels zuvor beschriebenen Schwenkachsen 44, dargestellt sind Achsen 44.1 und 44.3, kann der Deckel 24 am Basiskörper 22 festgelegt und verschwenkt, d.h. aufgeklappt werden, um das Innere der Prozesskammer 20 sowie Unter- und Oberwerkzeug zugänglich zu machen. Im Basiskörper 22 ist eine Pressenantrieb 34 angeordnet, der über einen Pressenstempel 114 einen Vorschub auf ein, in einem nicht dargestellten Werkstückträger aufgenommenen, Bauelement 130 relativ zum im Oberwerkzeug angeordneten Pressenwerkzeug 70 ausüben kann. Auf dem Bauelement 130 sind mehrere Bauteile 142, beispielsweise Leistungshalbleiterbauteile wie IGBTs oder ähnliches angeordnet. Die Bauteile 142 des Bauelements 130 können unterschiedliche Höhen aufweisen und sollen in einem Diffusionslöt-, Bond-, oder Sinterprozess auf dem Bauelement 130 verbunden werden, beispielsweise mit einer Kühlstruktur und Anschlussleitungen. Hierzu kann das Bauelement 130 zur Vermeidung von Verschmutzungen und zum Schutz mit einer, nicht dargestellten, Prozessabdeckung, beispielsweise einer Folie oder ähnlichem abgedeckt sein. Im Deckel 24 sind Fluidkanäle 156 zur Temperierung, d.h. zur Führung eines Heiz- oder Kühlfluids wie Öl oder Luft integriert.

Im Pressenwerkzeug 70 ist eine Heizplatte 124 angeordnet, die ebensolche Fluidkanäle zur Beheizung bzw. Abkühlung aufweisen kann. Nach unten begrenzt die Heizplatte 124 eine Druckkammer 90, in der ein Druckkissen eingelegt sein kann. Die Druck-kammer 90 weist einen Kammerbereich 144 auf, der steuerbar mit Fluid befüllbar ist. Das Fluid kann ein Gas oder eine Flüssigkeit sein. In dieser Ausführungsform ist vorgesehen, den Kammerbereich 144 mit Atmosphärengas der Prozesskammer 20 zu füllen, beispielsweise mit einem Reinigungsgas wie Stickstoff oder mit Luft. Hierzu sind im Deckel 24 zwei Füllventile 146 vorgesehen, die über Ventilaktuatoren 148 ein fluiddichtes Verschließen oder Öffnen des Kammerbereichs 144 der Druckkammer 90 gegenüber der Prozesskammer 20 ermöglicht.

Die Druckkammer 90 wird weiterhin in Richtung Unterwerkzeug mit einer Metallmembran als Membranteil 80 begrenzt. Die Metallmembran kann beispielsweise eine Stahlmembran, z.B. ein topfförmig ausgeformtes Stahlblech sein. Durch eine Fluidbefüllung des Kammerbereichs 144 kann die Metallmembran nach unten in Richtung Prozesskammer 20 ausgewölbt werden.

Unterhalb des Membranteils 80 ist eine Multistempeleinheit 150 angeordnet. Die Multistempeleinheit 150 umfasst eine Führungsplatte 154, die mehrere Pressstempel 152 aufnimmt und führt. Die Pressstempel 152 dienen zur selektiven Presskrafteinleitung in vordefinierbare Bereiche des Bauelements 130, und können von Form und Größe den verschiedenen geometrischen Abmessungen der Bauteile 142 angepasst sein, in die Presskraft eingeleitet werden soll. Bei einer Druckbeaufschlagung, d.h. einer Aktivierung des Pressenantriebs 34 werden die Pressstempel 152 innerhalb des Führungs- rahmens 154 in Richtung Bauelement 130 zur selektiven Presskraftausübung versetzt.

In dem in den Figs. 12a bis 12c dargestellten Ablauf soll - unabhängig von einer Presskrafterzeugung durch den Pressenantrieb 34 - eine Druckbeaufschlagung durch eine Auswölbung des Membranteils 80 aufgrund einer Druckdifferenz zwischen Prozess-kammer 20 und fluidbefüllbaren Kammerbereichen 144 der Druck-kammer 90 erfolgen. Die Größe der Druckkraft wird vom Druckunterschied zwischen Kammerbereich 144 und Prozesskammer 20 bestimmt, dieser bedingt eine Verdrängung des Membranteils 80 in Richtung Unterwerkzeug und übt dadurch einen Druck auf das Bauelement 130 aus.

In einem ersten Prozessschritt, dargestellt in Fig. 12a, sind die Fluidventile 146 in einer oberen Stellung, so dass der Kammerbereich 144 in Fluidverbindung mit der Prozesskammer 20 stehen. Im zweiten Prozessschritt wird die Prozess-kammer 20 vakuumiert, dies führt auch zur Vakuumierung des Kammerbereichs 144. Der erste und zweite Prozessschritt ist in Fig. 12a dargestellt.

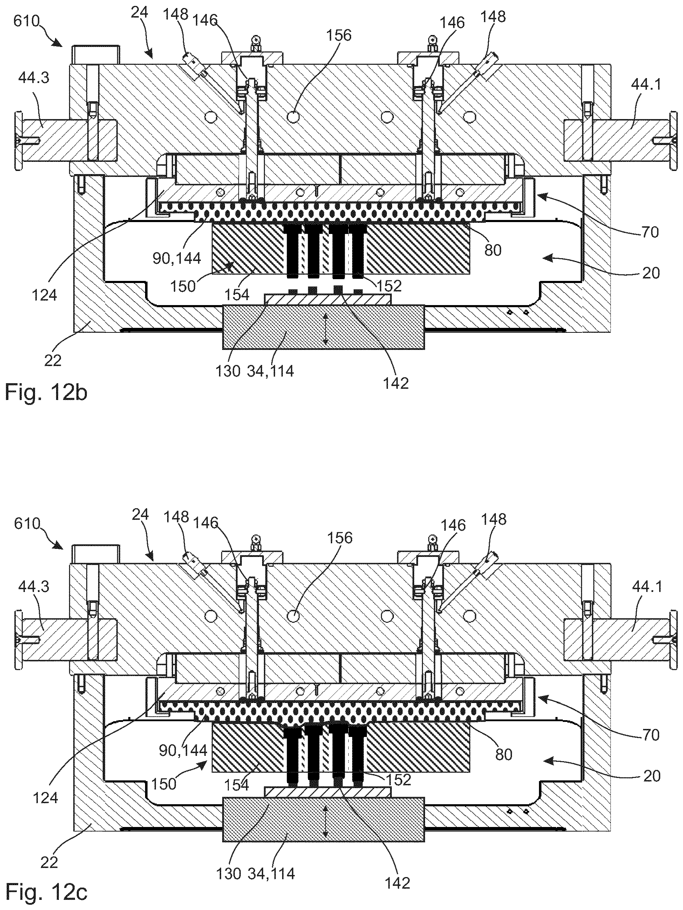

Im nachfolgenden dritten Prozessschritt wird die Prozesskammer 20 mit einem Reinigungsgas wie Stickstoff geflutet, das in den Kammerbereich 144 der Fluidkammer 90 eindringt. Anschließend wird im vierten Prozessschritt die Füll-ventile 146 mittels der Ventilaktuatoren 148 fluiddicht von der Prozesskammer 20 getrennt. Hiernach kann im fünften Prozessschritt der Pressenantrieb 34 soweit aktiviert werden, bis ein Werkstückträger (nicht dargestellt) mit dem Bauelement 130 und einer aufgelegten Prozessabdeckung (ebenfalls nicht dargestellt) an der Multistempeleinheit 154 benachbart anliegt. Die Schritte Drei bis Fünf sind in Fig. 12b gezeigt.

Im anschließenden sechsten Prozessschritt, dargestellt in Fig. 12c, wird die Prozesskammer 20 evakuiert. Dabei wölbt sich das Membranteil 80 aufgrund der Druckdifferenz zwischen Kammerbereich 144 der Druckkammer 90 und Prozesskammer 20 nach unten, und versetzt die Pressstempel 152 innerhalb dem Führungsrahme 154 in Richtung Bauelement 130, so dass auf den einzelnen Bauteilen 142 selektiv Druckkraft ausgeübt wird. Dabei können Höhenunterschiede der Bauteile 142 ausgeglichen werden, wobei abhängig von der Druckdifferenz die Presskraft fein dosierbar ist.

Diese aus der Druckdifferenz zwischen Prozesskammer 20 und Druckkammer 90 resultierende Druckbeaufschlagung kann alternativ oder zusätzlich zu einer durch den Pressenantrieb 34 ausgeübten Presskraft aufgebracht werden. Die hierdurch erzeugbare Drücke sind in der Regel geringer und feiner dosierbar als die mechanische Druckkraftbeaufschlagung mittels des Pressenantriebs 34. Hiermit kann ein Bondingverfahren, Diffusionslötverfahren oder Niederdrucksinterverfahren effektiv unterstützt werden.

Es versteht sich, dass verschiedene Merkmale der Diffusionslöt- oder Sintervorrichtungen 110, 210, 310, 410, 510, 610 miteinander kombiniert werden können, um weitere Varianten zu erhalten. So kann beispielsweise das erste obere Hartwerkzeug 120.1 durch das Pressenjoch 112 ersetzt sein. Weiterhin kann bei der Diffusionslöt- oder Diffusionslöt- oder Sintervorrichtung 110 (Fig. 10) die obere Trennfolie 132.1 auch entfallen, ähnlich wie bei der Diffusionslöt- oder Sintervorrichtung 310. Nach einer weiteren Abwandlung kann die Kombination aus dem Unterwerkzeug 122 und dem Druckkissen 90 auch durch das Presswerkzeug 70 (Fig. 8 und 9) ersetzt werden. In einer weiteren Abwandlung kann das Presswerkzeug 70 alternativ oder zusätzlich das obere Hartwerkzeug 120 bzw. 120.2 oder die Kombination aus beiden oberen Hartwerkzeugen 120.1, 120.2 ersetzen. In einer weiteren Abwandlung kann das Pressenjoch 112 durch den schwenkbaren Deckel 24 (Fig. 1 bis 7) gebildet sein. Weitere Ausführungsformen sind denkbar, die beispielsweise ein Druckkissen im Oberwerkzeug und im Unterwerkzeug integrieren. Auch ist es möglich, dass eine elastische Folie 140 im Unterwerkzeug, im Oberwerkzeug oder auch im Unterwerkzeug und im Oberwerkzeug vorgesehen ist.

### Bezugszeichenliste

- 10, 110, 210, 310, 410, 510, 610: Diffusionslöt- oder Sintervorrichtung
- 12: Gehäuse
- 14: Abdeckung
- 20: Prozesskammer
- 22: Basiskörper
- 23: Zugangsöffnung
- 24: Deckel
- 26: Betätigungsarm
- 28: Dichtring
- 30: Oberwerkzeug
- 32: Unterwerkzeug
- 34: Pressenantrieb
- 36: Gelenk
- 38: Werkstückträger
- 40: Verriegelungsvorrichtung
- 42.1 - 42.3: Riegelarm
- 44.1 - 44.3: Schwenkachse
- 46.1 - 46.3: Riegelabschnitt
- 48: Auslaufschräge
- 50.1 - 50.3: Riegelbolzen
- 51: Bolzenspiel
- 60.1, 60.3: Blockierhebel
- 62: Ausrückhebel
- 64: Koppelstange
- 66: Verriegelungssensor
- 70: Presswerkzeug
- 72: Grundplatte
- 74: Wandungsabschnitt
- 76: Dichtring
- 80: Membranteil
- 84: Klemmring
- 90: Druckkammer / Druckkissen
- 92: Pressfläche
- 112: Pressenjoch
- 114: Pressstempel
- 120, 120.1, 120.2: oberes Hartwerkzeug
- 122: Unterwerkzeug
- 124: Heizplatte
- 126: Druckring
- 128: Druckfeder
- 130: Bauelement, Komponente
- 132, 132.1, 132.2: Trennfolie
- 140: elastische Folie / Graphitfolie
- 142: Bauteil auf Bauelement
- 144: befüllbarer Kammerbereich der Fluidkammer
- 146: Füllventil
- 148: Ventilaktuator
- 150: Multistempeleinheit
- 152: Pressstempel
- 154: Führungsrahmen
- 156: Fluidkanäle zur Temperierung

## Patentansprüche

1. Sintervorrichtung oder Diffusionslötvorrichtung ( 10, 110, 210, 310, 410, 510) zum Verbinden von Komponenten wenigstens einer elektronischen Baugruppe mittels Drucksintern oder Diffusionslöten, umfassend eine evakuierbare Prozesskammer (20), in welcher ein Oberwerkzeug (30) und ein Unterwerkzeug (32) angeordnet ist, zwischen denen die Baugruppe aufgenommen ist und welche zum Ausüben einer Presskraft relativ zueinander bezüglich ihres Abstandes versetzbar sind, wobei die Prozesskammer (20) einen Basiskörper (22), welcher an seiner Oberseite eine Zugangsöffnung (23) aufweist, und einen Deckel (24) umfasst, welcher zwischen einer Schließstellung, in welcher die Zugangsöffnung (23) von dem Deckel (24) verschlossen ist, und einer Öffnungsstellung verstellbar ist, wobei sich das Oberwerkzeug (30) in der Schließstellung des Deckels (24) zumindest während des Ausübens der Presskraft an dem Deckel (24) abstützt, **dadurch gekennzeichnet, dass** die Prozesskammer (20) eine zwischen einer Verriegelungsstellung und einer Entriegelungsstellung verstellbare Verriegelungsvorrichtung (40) umfasst, welche dazu eingerichtet ist, in ihrer Verriegelungsstellung den Deckel (24) in seiner Schließstellung an dem Basiskörper (22) festzulegen, wobei die Verriegelungsvorrichtung (40) mehrere schwenkbare Riegelarme (42.1 - 42.3) aufweist, welche in der Verriegelungsstellung sowohl mit dem Deckel (24) als auch mit dem Basiskörper (22) formschlüssig verbunden sind, wobei jeder der Riegelarme (42.1 - 42.3) an seinem ersten Ende um eine jeweilige Schwenkachse (44.1 - 44.3) schwenkbar am Deckel (24) befestigt ist und aufgrund der Schwerkraft pendelnd am Deckel (24) gelagert sind, und an seinem zweiten Ende einen Riegelabschnitt (46.1 - 46.3) aufweist, an welchem Einlaufschrägen ausgebildet sind, sodass in der Verriegelungsstellung der Riegelabschnitt (46.1 - 46.3) mit einem jeweiligen, dem Riegelarm (42.1 - 42.3) zugeordneten, an dem Basiskörper (22) befestigten Riegelbolzen (50.1 - 50.3) verriegelt ist.

2. Sintervorrichtung oder Diffusionslötvorrichtung ( 10, 110, 210, 310, 410, 510) nach Anspruch 1, **dadurch gekennzeichnet, dass** der Deckel (24) um eine Kippachse schwenkbar an dem Basiskörper (22) angelenkt ist, wobei bevorzugt am Deckel (24) ein zum Verschwenken des Deckels (24) eingerichteter Betätigungsarm (26) befestigt ist.

3. Sintervorrichtung oder Diffusionslötvorrichtung ( 10, 110, 210, 310, 410, 510) nach Anspruch 1, **dadurch gekennzeichnet, dass** sich die Zugangsöffnung (23), der Deckel (24) in seiner Schließstellung und die Schwenkachsen (44.1 - 44.3) der Riegelarme (42.1 - 42.3) in einer jeweiligen horizontalen Ebene erstrecken.

4. Sintervorrichtung oder Diffusionslötvorrichtung ( 10, 110, 210, 310, 410, 510) nach Anspruch 1 oder 3, **dadurch gekennzeichnet, dass** die Riegelarme (42.1 - 42.3) an zwei einander gegenüberliegenden Seitenflächen des Deckels (24) angeordnet sind.

5. Sintervorrichtung oder Diffusionslötvorrichtung ( 10, 110, 210, 310, 410, 510) nach Anspruch 4, **dadurch gekennzeichnet, dass** die Verriegelungsvorrichtung (40) genau drei Riegelarme (42.1 - 42.3) aufweist, wobei ein erster und ein zweiter Riegelarm (42.1 - 42.3) an der einen Seitenfläche und ein dritter Riegelarm (42.1 - 42.3) an der anderen Seitenfläche angeordnet ist.

6. Sintervorrichtung oder Diffusionslötvorrichtung ( 10, 110, 210, 310, 410, 510) nach Anspruch 5, **dadurch gekennzeichnet, dass** die Schwenkachsen (44.1 - 44.3) der Riegelarme (42.1 - 42.3) sowie die diesen Riegelarmen (42.1 - 42.3) zugeordneten Riegelbolzen (50.1 - 50.3) derart angeordnet sind, dass die Wirkrichtung einer Zuhaltungskraft, welche aufgrund des Ausübens der Presskraft zwischen dem Deckel (24) und dem Basiskörper (22) über einen jeweiligen verriegelten Riegelarm (42.1 - 42.3) übertragen wird, zumindest für den ersten und den zweiten Riegelarm (42.1, 42.2) parallel zur Wirkrichtung der Presskraft verläuft, und bevorzugt für den dritten Riegelarm (42.3) schräg zur Wirkrichtung der Presskraft verläuft.

7. Sintervorrichtung oder Diffusionslötvorrichtung ( 10, 110, 210, 310, 410, 510) nach Anspruch 5 oder 6, **dadurch gekennzeichnet, dass** der erste und der zweite Riegelarm (42.1 - 42.3) derart über eine Koppelstange (64) verbunden sind, dass der erste und der zweite Riegelarm (42.1, 42.2) synchron zwischen der Verriegelungsstellung und der Entriegelungsstellung versetzbar sind.

8. Sintervorrichtung oder Diffusionslötvorrichtung ( 10, 110, 210, 310, 410, 510) nach einem der Ansprüche 5 bis 7, **dadurch gekennzeichnet, dass** eine Massenverteilung des dritten Riegelarms (42.3) und die Positionen der Schwenkachse des dritten Riegelarms (42.3) und des dem dritten Riegelarm (42.1 - 42.3) zugeordneten Riegelbolzens (50.3) asymmetrisch in Bezug auf eine gedachte Symmetrieebene, welche bei verriegeltem Riegelarm (42.3) zwischen der Schwenkachse und einer parallel zur Schwenkachse verlaufenden Symmetrieachse des Riegelbolzens (50.3) aufgespannt wird, verläuft, sodass der dritte Riegelarm (42.3) bei geschlossenem Deckel (24) bei einem Fehlen zusätzlicher Kräfte alleine durch den Einfluss der Schwerkraft in seiner Verriegelungsstellung gehalten wird.

9. Sintervorrichtung oder Diffusionslötvorrichtung ( 10, 110, 210, 310, 410, 510) nach einem der Ansprüche 1 oder 3 bis 8, **dadurch gekennzeichnet, dass** wenigstens ein, bevorzugt als Kniehebel ausgebildeter, mit einem jeweiligen zugeordneten Riegelarm (42.1 - 42.3) zusammenwirkender Blockierhebel (60.1, 60.3) vorgesehen ist, welcher zwischen einer Blockierstellung, in welcher der Blockierhebel (60.1, 60.3) den Riegelarm (42.1 - 42.3) in seiner Verriegelungsstellung gegen ein Versetzen blockiert, und einer Freigabestellung, in welcher der Blockierhebel (60.1, 60.3) den Riegelarm (42.1 - 42.3) für ein Versetzen freigibt, versetzbar ist, und/oder dass wenigstens ein, bevorzugt als Kniehebel ausgebildeter, mit einem jeweiligen zugeordneten Riegelarm (42.1 - 42.3) zusammenwirkender Ausrückhebel (62) vorgesehen ist, welcher dazu eingerichtet ist, den Riegelarm (42.1 - 42.3) von seiner Verriegelungsstellung in seine Entriegelungsstellung zu versetzen.

10. Sintervorrichtung oder Diffusionslötvorrichtung (10, 110, 210, 310, 410, 510) nach einem der vorhergehenden Ansprüche, umfassend ein Pressenjoch (112), an welchem das Oberwerkzeug (30, 120, 120.1, 120.2) angeordnet ist, wobei zwischen dem Pressenjoch (112) und dem Oberwerkzeug (30, 120, 120.1, 120.2) und / oder im Unterwerkzeug (32,122) eine elastische Folie (140), bevorzugt eine Graphitfolie, angeordnet ist.

11. Sintervorrichtung oder Diffusionslötvorrichtung (10, 110, 210, 310, 410, 510) nach Anspruch 10, **dadurch gekennzeichnet, dass** das Unterwerkzeug (32, 122) an einer der Baugruppe zugewandten Seite einen ein mit einem Fluid befülltes Druckkissen (90) aufweist.

12. Sintervorrichtung oder Diffusionslötvorrichtung (10, 110, 210, 310, 410, 510) nach einem der vorhergehenden Ansprüche, weiterhin umfassend ein Presswerkzeug (70) für das Oberwerkzeug (30, 120, 120.1, 120.2) oder das Unterwerkzeug (32, 122), das eine starre Grundplatte (72), ein mit der Grundplatte (72) verbundenes Membranteil (80) in Richtung Pressfläche (92), welches durch eine biegsame, vorzugsweise topfförmig geformte, bevorzugt aus Silikon oder einer Stahllegierung hergestellte Membran gebildet ist, und ein mit einer Druckkammer, die vorzugsweise ein mit einem Fluid befülltes Druckkissen (90) beinhaltet, welches in einem abgeschlossenen Aufnahmeraum angeordnet ist, welcher durch die Grundplatte (72) und das Membranteil (80) begrenzt ist, aufweist.

13. Sintervorrichtung oder Diffusionslötvorrichtung (10, 110, 210, 310, 410, 510) nach Anspruch 12, **dadurch gekennzeichnet, dass** das Membranteil (80) einen umlaufenden Randabschnitt aufweist, welcher zwischen der Grundplatte (72) und einem mit der Grundplatte (72) verbundenen, bevorzugt verschraubten Klemmring (84) eingespannt ist.

14. Sintervorrichtung oder Diffusionslötvorrichtung (10, 110, 210, 310, 410, 510) nach Anspruch 12 oder 13, **dadurch gekennzeichnet, dass** zumindest ein Teilbereich der Druckkammer, insbesondere des Druckkissens (90) steuerbar fluidbefüllbar, insbesondere Gasbefüllbar ist, bevorzugt mittels zumindest eines Füllventils (146) befüllbar ist.

15. Sintervorrichtung oder Diffusionslötvorrichtung (10, 110, 210, 310, 410, 510) nach einem der Ansprüche 12 bis 14, **dadurch gekennzeichnet, dass** unterhalb des Membranteils (80) eine Multistempeleinheit (150) mit einer Mehrzahl von Pressstempeln (152), die in einem Führungsrahmen (154) geführt sind, angeordnet ist.

## Claims

1. Sintering device or diffusion soldering device (10, 110, 210, 310, 410, 510) for connecting components of at least one electronic assembly by means of pressure sintering or diffusion soldering, comprising an evacuatable process chamber (20) in which an upper tool (30) and a lower tool (32) are arranged, between which the assembly is held and which are displaceable relative to one another in their distance apart to exert a press force, wherein the process chamber (20) comprises a base body (22) having on its upper side an access opening (23) and a cover (24) which is adjustable between a closed position in which the access opening (23) is closed by the cover (24) and an open position, wherein the upper tool (30) is supported on the cover (24) in the closed position of the cover (24) at least during the exertion of the press force, **characterized in that** the process chamber (20) comprises a locking device (40) movable between a locked position and an unlocked position, which in its locked position is configured to fix the cover (24) in its closed position on the base body (22), wherein the locking device (40) has several swivelable locking arms (42.1 - 42.3) which in the locked position are positively connected both to the cover (24) and to the base body (22), wherein each of the locking arms (42.1 - 42.3) is fastened with its first end to the cover (24) swivelably about a respective swivel axis (44.1 - 44.3) and is mounted on the cover (24) so as to oscillate due to gravity, and has at its second end a respective locking section (46.1 - 46.3) on which inlet bevels are formed, so that in the locked position the locking section (46.1 - 46.3) is locked with a respective locking bolt (50.1 - 50.3) assigned to the locking arm (42.1 - 42.3) and fastened to the base body (22).2. Sintering device or diffusion soldering device (10, 110, 210, 310, 410, 510) according to claim 1, **characterized in that** the cover (24) is swivelably jointed to the base body (22) about a tilting axis, wherein preferably an actuating arm (26) configured to swivel the cover (24) is fastened to the cover (24).

2. Sintering device or diffusion soldering device (10, 110, 210, 310, 410, 510) according to claim 1, **characterized in that** the cover (24) is swivelably jointed to the base body (22) about a tilting axis, wherein preferably an actuating arm (26) configured to swivel the cover (24) is fastened to the cover (24).

3. Sintering device or diffusion soldering device (10, 110, 210, 310, 410, 510) according to claim 1, **characterized in that** the access opening (23), the cover (24) in its locked position and the swivel axes (44.1 - 44.3) of the locking arms (42.1 - 42.3) extend in a respective horizontal plane.

4. Sintering device or diffusion soldering device (10, 110, 210, 310, 410, 510) according to claim 1 or 3, **characterized in that** the locking arms (42.1 - 42.3) are arranged on two side surfaces of the cover (24) opposite one another.

5. Sintering device or diffusion soldering device (10, 110, 210, 310, 410, 510) according to claim 4, **characterized in that** the locking device (40) has precisely three locking arms (42.1 - 42.3), wherein a first and a second locking arm (42.1 - 42.3) are arranged on the one side surface and a third locking arm (42.1 - 42.3) on the other side surface.

6. Sintering device or diffusion soldering device 10, 110, 210, 310, 410, 510) according to claim 5, **characterized in that** the swivel axes (44.1 - 44.3) of the locking arms (42.1 - 42.3) and the locking bolts (50.1 - 50.3) associated with these locking arms (42.1 - 42.3) are arranged such that the effective direction of a locking force, which is transmitted due to the exertion of the press force between the cover (24) and the base body (22) via a respective locked locking arm (42.1 - 42.3), extends at least for the first and the second locking arms (42.1, 42.2) parallel to the effective direction of the press force and preferably extends for the third locking arm (42.3) obliquely to the effective direction of the press force.

7. Sintering device or diffusion soldering device (10, 110, 210, 310, 410, 510) according to claim 5 or 6, **characterized in that** the first and the second locking arm (42.1 - 42.3) are connected via a coupling rod (64) such that the first and the second locking arm (42.1, 42.2) are synchronously movable between the locked position and the unlocked position.

8. Sintering device or diffusion soldering device (10, 110, 210, 310, 410, 510) according to any of claims 5 to 7, **characterized in that** a distribution of mass of the third locking arm (42.3) and the positions of the swivel axis of the third locking arm (42.3) and of the locking bolt (50.3) associated with the third locking arm (42.1 - 42.3) is asymmetrical with respect to an imaginary plane of symmetry, which is spanned between the swivel axis and an axis of symmetry of the locking bolt (50.3) extending parallel to the swivel axis when the locking arm (42.3) is locked, so that the third locking arm (42.3) is held in its locked position solely by the effect of gravity when the cover (24) is closed and in the absence of additional forces.

9. Sintering device or diffusion soldering device (10, 110, 210, 310, 410, 510) according to any of claims 1 or 3 to 8, **characterized in that** at least one blocking lever (60.1, 60.3) preferably designed as a toggle lever and interacting with a respective associated locking arm (42.1 - 42.3) is provided which is movable between a blocking position in which the blocking lever (60.1, 60.3) blocks the locking arm (42.1 - 42.3) in its locked position against a movement and a release position in which the blocking lever (60.1, 60.3) releases the locking arm (42.1 - 42.3) for a movement, and/or **in that** at least one release lever (62) preferably designed as a toggle lever and interacting with a respective associated locking arm (42.1 - 42.3) is provided which is configured to move the locking arm (42.1 - 42.3) from its locked position to its unlocked position.

10. Sintering device or diffusion soldering device (10, 110, 210, 310, 410, 510) according to any of the preceding claims, comprising a press yoke (112) on which the upper tool (30, 120, 120.1, 120.2) is arranged, wherein an elastic foil (140), preferably a graphite foil, is arranged between the press yoke (112) and the upper tool (30, 120, 120.1, 120.2) and/or in the lower tool (32, 122).

11. Sintering device or diffusion soldering device (10, 110, 210, 310, 410, 510) according to claim 10, **characterized in that** the lower tool (32, 122) has a fluid-filled pressure pad (90) on a side facing the assembly.

12. Sintering device or diffusion soldering device (10, 110, 210, 310, 410, 510) according to any of the preceding claims, further comprising a press tool (70) for the upper tool (30, 120, 120.1, 120.2) or the lower tool (32, 122), that has a rigid baseplate (72), a membrane part (80) connected to the baseplate (72) in the direction of the press surface (92) and formed by a flexible, preferably dish-shaped membrane preferably made from silicone or a steel alloy, and containing a pressure chamber preferably comprising a pressure pad (90) filled with a fluid and arranged in a closed receiving area limited by the baseplate (72) and the membrane part (80).

13. Sintering device or diffusion soldering device (10, 110, 210, 310, 410, 510) according to claim 12, **characterized in that** the membrane part (80) has an all-round rim section clamped between the baseplate (72) and a clamping ring (84) connected, preferably bolted, to the baseplate (72).

14. Sintering device or diffusion soldering device (10, 110, 210, 310, 410, 510) according to claim 12 or 13, **characterized in that** at least one sub-area of the pressure chamber, in particular of the pressure pad (90), is controllably fluid-fillable, in particular gas-fillable, preferably by means of at least one filler valve (146).

15. Sintering device or diffusion soldering device (10, 110, 210, 310, 410, 510) according to any of claims 12 bis 14, **characterized in that** a multi-plunger unit (150) with a plurality of press plungers (152) guided in a guide frame (154) is arranged underneath the membrane part (80).

## Revendications

1. Dispositif de frittage ou dispositif de brasage par diffusion (10, 110, 210, 310, 410, 510) pour assembler des composants d'au moins un module électronique au moyen de frittage sous pression ou de brasage par diffusion, comprenant une chambre de processus évacuable (20) dans laquelle un outil supérieur (30) et un outil inférieur (32) sont disposés, entre lesquels le module est logé et qui sont décalables concernant leur écartement pour exercer une force de pression l'un par rapport à l'autre, sachant que la chambre de processus (20) présente un corps de base (22) qui présente une ouverture d'accès (23) sur sa face supérieure, et un couvercle (24) qui est déplaçable entre une position de fermeture dans laquelle l'ouverture d'accès (23) est fermée par le couvercle (24), et une position d'ouverture, sachant que l'outil supérieur (30) s'appuie sur le couvercle (24), dans la position de fermeture du couvercle (24) au moins pendant l'exercice de la force de pression, **caractérisé en ce que** la chambre de processus (20) comprend un dispositif de verrouillage (40) déplaçable entre une position de verrouillage et une position de déverrouillage, qui est configuré pour fixer, dans sa position de verrouillage, le couvercle (24) contre le corps de base (22) dans la position de fermeture du couvercle, sachant que le dispositif de verrouillage (40) présente plusieurs bras de verrouillage (42.1 - 42.3) pivotables qui sont reliés par complémentarité de forme aussi bien au couvercle (24) qu'au corps de base (22), dans la position de verrouillage, sachant que chacun des bras de verrouillage (42.1 - 42.3) est fixé, par sa première extrémité, au couvercle (24) de manière pivotable autour d'un axe de pivotement respectif (44.1 - 44.3) et est monté au couvercle (24) de manière à osciller en raison de la force de gravité, et présente, au niveau de sa seconde extrémité, une section de verrouillage (46.1 - 46.3) au niveau de laquelle sont constitués des chanfreins d'entrée de sorte que dans la position de verrouillage, la section de verrouillage (46.1 - 46.3) est verrouillée avec un boulon de verrouillage (50.1 - 50.3) respectif, associé au bras de verrouillage (42.1 - 42.3) et fixé au corps de base (22).

2. Dispositif de frittage ou dispositif de brasage par diffusion (10, 110, 210, 310, 410, 510) selon la revendication 1, **caractérisé en ce que** le couvercle (24) est articulé sur le corps de base (22) de manière à pouvoir pivoter autour d'un axe de basculement, sachant qu'un bras d'actionnement (26) configuré pour faire pivoter le couvercle (24) est fixé, de préférence, au couvercle (24).

3. Dispositif de frittage ou dispositif de brasage par diffusion (10, 110, 210, 310, 410, 510) selon la revendication 1, **caractérisé en ce que** l'ouverture d'accès (23), le couvercle (24) dans sa position de fermeture et les axes de pivotement (44.1 - 44.3) des bras de verrouillage (42.1 - 42.3) s'étendent dans un plan horizontal respectif.

4. Dispositif de frittage ou dispositif de brasage par diffusion (10, 110, 210, 310, 410, 510) selon la revendication 1 ou 3, **caractérisé en ce que** les bras de verrouillage (42.1 - 42.3) sont disposés sur deux surfaces latérales opposées du couvercle (24).

5. Dispositif de frittage ou dispositif de brasage par diffusion (10, 110, 210, 310, 410, 510) selon la revendication 4, **caractérisé en ce que** le dispositif de verrouillage (40) présente exactement trois bras de verrouillage (42.1 - 42.3), sachant qu'un premier et un second bras de verrouillage (42.1 - 42.3) sont disposés sur l'une des surfaces latérales et un troisième bras de verrouillage (42.1 - 42.3) sur l'autre.

6. Dispositif de frittage ou dispositif de brasage par diffusion (10, 110, 210, 310, 410, 510) selon la revendication 5, **caractérisé en ce que** les axes de pivotement (44.1 - 44.3) des bras de verrouillage (42.1 - 42.3) ainsi que les boulons de verrouillage (50.1 - 50.3) associés à ces bras de verrouillage (42.1 - 42.3) sont disposés de sorte que le sens d'action d'une force de fermeture qui, en raison de l'exercice de la force de pression entre le couvercle (24) et le corps de base (22), est transmise via un bras de verrouillage (42.1 - 42.3) respectif verrouillé, s'étend parallèlement au sens d'action de la force de pression au moins pour le premier et le second bras de verrouillage (42.1, 42.2) et s'étend de préférence en biais par rapport au sens d'action de la force de pression pour le troisième bras de verrouillage (42.3).

7. Dispositif de frittage ou dispositif de brasage par diffusion (10, 110, 210, 310, 410, 510) selon la revendication 5 ou 6, **caractérisé en ce que** le premier et le second bras de verrouillage (42.1 - 42.3) sont reliés via une tige de couplage (64) de sorte que le premier et le second bras de verrouillage (42.1, 42.2) sont décalables de manière synchrone entre la position de verrouillage et la position de déverrouillage.

8. Dispositif de frittage ou dispositif de brasage par diffusion (10, 110, 210, 310, 410, 510) selon l'une des revendications 5 à 7, **caractérisé en ce qu'**une répartition de la masse du troisième bras de verrouillage (42.3) et les positions de l'axe de pivotement du troisième bras de verrouillage (42.3) et du boulon de verrouillage (50.3) associé au troisième bras de verrouillage (42.1 - 42.3) s'étendent de manière asymétrique par rapport à un plan de symétrie imaginé qui est sous-tendu, pour le bras de verrouillage (42.3) verrouillé, entre l'axe de pivotement et un axe de symétrie du boulon de verrouillage (50.3) s'étendant parallèlement à l'axe de pivotement, de sorte que lorsque le couvercle est fermé (24), le troisième bras de verrouillage (42.3) est retenu dans sa position de verrouillage uniquement par l'influence de la force de gravité, en l'absence de forces supplémentaires.

9. Dispositif de frittage ou dispositif de brasage par diffusion (10, 110, 210, 310, 410, 510) selon l'une des revendications 1 ou 3 à 8, **caractérisé en ce qu'**est prévu au moins un levier de blocage (60.1, 60.3) conçu de préférence sous forme de levier à rotule, interagissant avec un arbre de verrouillage (42.1 - 42.3) respectif associé, lequel levier de blocage est décalable entre une position de blocage dans laquelle le levier de blocage (60.1, 60.3) bloque le levier de verrouillage (42.1 - 42.3) dans sa position de verrouillage, empêchant un décalage, et une position de libération dans laquelle le levier de blocage (60.1, 60.3) libère le bras de verrouillage (42.1 - 42.3) pour un décalage, et/ou qu'est prévu au moins un levier de dégagement (62) conçu de préférence sous forme de levier à rotule, interagissant avec un arbre de verrouillage (42.1 - 42.3) respectif associé qui est configuré pour décaler le bras de verrouillage (42.1 - 42.3) de sa position de verrouillage à sa position de déverrouillage.

10. Dispositif de frittage ou dispositif de brasage par diffusion (10, 110, 210, 310, 410, 510) selon l'une des revendications précédentes, comprenant un croisillon de presse (112) sur lequel est disposé l'outil supérieur (30, 120, 120.1, 120.2) et sachant qu'un film élastique (140), de préférence une feuille de graphite, est disposé entre le croisillon de presse (112) et l'outil supérieur (30, 120, 120.1, 120.2) et/ou dans l'outil inférieur (32, 122).

11. Dispositif de frittage ou dispositif de brasage par diffusion (10, 110, 210, 310, 410, 510) selon la revendication 10, **caractérisé en ce que** l'outil inférieur (32, 122) présente un coussin de pression (90) rempli d'un fluide, sur un côté tourné vers le module.

12. Dispositif de frittage ou dispositif de brasage par diffusion (10, 110, 210, 310, 410, 510) selon l'une des revendications précédentes, comprenant également un outil de pression (70) pour l'outil supérieur (30, 120, 120.1, 120.2) ou l'outil inférieur (32, 122) qui présente une plaque de base rigide (72), un élément à membrane (80) relié à la plaque de base (72) dans le sens de la surface de pression (92), qui est formé par une membrane souple, de préférence en forme de pot, constituée de préférence de silicone ou d'un alliage d'acier, et par un élément avec une chambre de pression qui contient de préférence un coussin de pression (90) rempli d'un fluide, lequel coussin de pression est disposé dans un espace de logement fermé qui est délimité par la plaque de base (72) et l'élément à membrane (80).

13. Dispositif de frittage ou dispositif de brasage par diffusion (10, 110, 210, 310, 410, 510) selon la revendication 12, **caractérisé en ce que** l'élément à membrane (80) présente une section périphérique circonférentielle qui est encastrée entre la plaque de base (72) et un anneau de serrage (84) relié à la plaque de base (72), de préférence vissé à celle-ci.

14. Dispositif de frittage ou dispositif de brasage par diffusion (10, 110, 210, 310, 410, 510) selon la revendication 12 ou 13, **caractérisé en ce qu'**au moins une zone partielle de la chambre de pression, notamment du coussin de pression (90) est remplissable avec du fluide, de manière pilotable, notamment remplissable avec du gaz, de préférence au moyen d'au moins une soupape de remplissage (146).

15. Dispositif de frittage ou dispositif de brasage par diffusion (10, 110, 210, 310, 410, 510) selon l'une des revendications 12 à 14, **caractérisé en ce qu'**en dessous de l'élément à membrane (80), est disposée une unité multi-tampons (150) avec une pluralité de tampons de pression (152) qui sont conduits dans un cadre de guidage (154).
